# EUROPEAN PATENT APPLICATION

(11) **EP 4 683 477 A1**
(43) Date of publication of application: **21.01.2026**
(21) Application number: 25187747.8
(22) Date of filing: 07.07.2025
(51) Int. Cl.: H10K 59/38, H10K 59/80

(54) **DISPLAY DEVICE AND ELECTRONIC DEVICE INCLUDING THE SAME**

(30) Priority: 18.07.2024 KR 20240094938
(71) Applicant: Samsung Display Co., Ltd., Yongin-si, Gyeonggi-do 17113 (KR)
(72) Inventor: HONG, Sang Min, 17113 Giheung-gu, Yongin-si, Gyeonggi-do (KR); KIM, Se Hee, 17113 Giheung-gu, Yongin-si, Gyeonggi-do (KR); KIM, Seung Han, 17113 Giheung-gu, Yongin-si, Gyeonggi-do (KR); HEO, Na Ri, 17113 Giheung-gu, Yongin-si, Gyeonggi-do (KR)
(74) Representative: Dr. Weitzel & Partner

(57) **Abstract**

A display device according to the present embodiments includes a substrate with a display area including emission areas of a first pixel, a second pixel, and a third pixel and a non-emission area surrounding the emission areas, light emitting elements provided in the emission areas, a color filter layer including color filters provided in the emission areas and a first light blocking layer provided in the non-emission area, and a second light blocking layer provided on the color filter layer in the non-emission area of the second pixel and the third pixel while surrounding the emission areas of the second pixel and the third pixel. The second light blocking layer may include openings having a width larger than a width of the light emitting elements in the second pixel and openings having a width smaller than or equal to a width of the light emitting elements in the third pixel.

## Description

### BACKGROUND

### 1. Field

One or more aspects of embodiments of the present invention relate to a display device and an electronic device including the same.

### 2. Description of the Related Art

With the increase in the use of display devices in society, there is a greater demand for display devices capable of displaying images in various ways.

In an effort to accommodate this increased demand, one or more suitable types (kinds) of display devices including a light emitting display device are being developed.

### SUMMARY

The invention is defined by the independent claims. One or more aspects of embodiments of the present invention provide a display device capable of varying a viewing angle depending on an emission mode and an electronic device including the same.

However, aspects of the present invention are not restricted to the one set forth herein. The above and other aspects of the present invention will become more apparent to one of ordinary skill in the art to which the present invention pertains by referencing the detailed description of the present invention given herein below.

According to the present invention, there is provided a display device including, a substrate including a display area including emission areas of a first pixel, a second pixel, and a third pixel and a non-emission area around (e.g., surrounding) the emission areas, a light emitting element layer arranged on the substrate and including light emitting elements arranged in the emission areas, a color filter layer arranged on the light emitting element layer and including color filters arranged in the emission areas and a first light blocking layer arranged in the non-emission area, and a second light blocking layer arranged on the color filter layer and arranged in the non-emission area of the second pixel and the third pixel while around (e.g., surrounding) the emission areas of the second pixel and the third pixel. The second light blocking layer may include openings having a width larger than a width of the light emitting elements of the second pixel in the second pixel and openings having a width smaller than or equal to a width of the light emitting elements of the third pixel in the third pixel.

In one or more embodiments, the light emitting element layer may further include a pixel defining layer arranged in the non-emission area and including openings corresponding to the emission areas, and the light emitting elements may be arranged in the openings of the pixel defining layer.

In one or more embodiments, in the second pixel, the width of the openings of the second light blocking layer may be larger than a width of the openings of the pixel defining layer.

In one or more embodiments, in the second pixel, the openings of the second light blocking layer may surround the openings of the pixel defining layer and may be spaced apart from the openings of the pixel defining layer in plan view.

In one or more embodiments, the second light blocking layer may not overlap the light emitting elements arranged in the second pixel in plan view.

In one or more embodiments, in the third pixel, the width of the openings of the second light blocking layer may be smaller than or equal to a width of the openings of the pixel defining layer.

In one or more embodiments, in the third pixel, the openings of the second light blocking layer may have the same width as the openings of the pixel defining layer and may completely overlap the openings of the pixel defining layer.

In one or more embodiments, in plan view, the second light blocking layer may be in contact with a perimeter of the light emitting elements arranged in the third pixel.

In one or more embodiments, in the third pixel, the openings of the second light blocking layer may have a smaller width than the width of the openings of the pixel defining layer and may be arranged inside the openings of the pixel defining layer.

In one or more embodiments, a portion of the second light blocking layer may cover an edge portion of the light emitting elements arranged in the third pixel.

In one or more embodiments, the first light blocking layer may include openings corresponding to and exposing the emission areas.

In one or more embodiments, a size of the openings of the first light blocking layer exposing the emission areas of the first pixel may be larger than a size of the openings of the second light blocking layer exposing the emission areas of the second pixel and the third pixel.

In one or more embodiments, a distance between the first light blocking layer and the light emitting elements arranged in the first pixel may be greater than a distance between the first light blocking layer and the light emitting elements arranged in the second pixel and the third pixel.

In one or more embodiments, the first light blocking layer may be spaced apart by a substantially uniform distance from the light emitting elements arranged in the first pixel, the second pixel, and the third pixel in plan view.

In one or more embodiments, in the second pixel, the openings of the first light blocking layer and the openings of the second light blocking layer may have the same size.

In one or more embodiments, in the second pixel, the openings of the first light blocking layer may completely overlap the openings of the second light blocking layer in plan view.

In one or more embodiments, in the third pixel, the width of the openings of the first light blocking layer may be larger than the width of the openings of the second light blocking layer.

In one or more embodiments, in the third pixel, the openings of the second light blocking layer may be arranged inside the openings of the first light blocking layer in plan view.

In one or more embodiments, the second light blocking layer may be disposed only in some pixels, the some pixels including the second pixel and the third pixel, among pixels arranged in the display area, and may be not arranged in other pixels.

In one or more embodiments, the first light blocking layer may be arranged in a non-emission area of all pixels arranged in the display area, the all pixels including the first pixel, the second pixel, and the third pixel.

According to the present invention, there is provided an electronic device including a display device. The display device includes a substrate including a display area including emission areas of a first pixel, a second pixel, and a third pixel and a non-emission area around (e.g., surrounding) the emission areas, a light emitting element layer arranged on the substrate and including light emitting elements arranged in the emission areas, a color filter layer arranged on the light emitting element layer and including color filters arranged in the emission areas and a first light blocking layer arranged in the non-emission area, and a second light blocking layer arranged on the color filter layer and arranged in the non-emission area of the second pixel and the third pixel while around (e.g., surrounding) the emission areas of the second pixel and the third pixel. The second light blocking layer may include openings having a width larger than a width of the light emitting elements of the second pixel in the second pixel and openings having a width smaller than or equal to a width of the light emitting elements of the third pixel in the third pixel.

The display device according to one or more embodiments includes a first pixel, a second pixel, and a third pixel with different side light emission ratios. In one or more embodiments, a second light blocking layer may not be arranged in the first pixel, and the second light blocking layer with different aperture ratios and/or opening areas may be arranged in the second pixel and the third pixel. Accordingly, the side light emission ratios and/or light exit angles of the first pixel, the second pixel, and the third pixel may be differentiated.

According to one or more embodiments, by selectively driving the first pixel, the second pixel, and the third pixel depending on each emission mode, the viewing angle of the display device may be appropriately or suitably varied. Additionally, even in an emission mode that limits the viewing angle by turning off the first pixel and driving at least one selected from among the second pixel and the third pixel, the luminance and viewing angle of the display device may be further adjusted by selectively driving the second and third pixels. Accordingly, more diverse emission modes may be provided to a user and the convenience of use of the display device may be increased.

However, effects according to the embodiments of the present invention are not limited to those exemplified above and one or more suitable other effects are incorporated herein.

### BRIEF DESCRIPTION OF THE DRAWINGS

The above and other aspects and features of the present invention will become more apparent by describing in more detail embodiments thereof with reference to the attached drawings, in which:
FIG. 1 is a perspective view showing an electronic device according to one or more embodiments;
FIG. 2 is a perspective view illustrating a display device included in an electronic device according to one or more embodiments;
FIG. 3 is a cross-sectional view of the display device of FIG. 2 viewed from the side;
FIG. 4 is a plan view illustrating a display area of a display device according to one or more embodiments;
FIG. 5 is a plan view showing light emitting elements and a first light blocking layer according to one or more embodiments;
FIG. 6 is a plan view showing light emitting elements and a first light blocking layer according to one or more embodiments;
FIG. 7 is a plan view showing light emitting elements and a second light blocking layer according to one or more embodiments;
FIG. 8 is a plan view showing light emitting elements and a second light blocking layer according to one or more embodiments;
FIG. 9 is a cross-sectional view illustrating a display device according to one or more embodiments;
FIG. 10 is a cross-sectional view showing a display device according to one or more embodiments;
FIG. 11 is a cross-sectional view showing a display device according to one or more embodiments; and
FIG. 12 is a cross-sectional view illustrating a display device according to one or more embodiments.

### DETAILED DESCRIPTION

The present invention will now be described more fully hereinafter with reference to the accompanying drawings, in which embodiments of the invention are shown. This invention may, however, be embodied in different forms and should not be construed as limited to the embodiments set forth herein. Rather, these embodiments are provided so that this invention will be thorough and complete, and will fully convey the scope of the invention to those skilled in the art.

It will also be understood that when an element or a layer is referred to as being "on" another element or layer, it can be directly on the other element or layer, or intervening layers may also be present. For example, when a layer, region, or component is referred to as being "electrically connected" or "electrically coupled" to another layer, region, or component, it can be directly electrically connected or coupled to the other layer, region, and/or component or intervening layers, regions, or components may be present. By way of contrast, when an element or a layer is referred to as being "directly on" another element or layer, no intervening layers may be present. The same reference numbers indicate the same components throughout the specification.

It will be understood that, although the terms "first," "second," and/or the like may be used herein to describe one or more suitable elements, these elements should not be limited by these terms. These terms are only used to distinguish one element from another element. For instance, a first element discussed below could be termed a second element without departing from the teachings of the present invention. Similarly, the second element could also be termed the first element.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the particular illustrated shapes of regions, but are to include deviations in shapes that result from, for instance, manufacturing. In the drawings, the relative sizes of elements, layers, and regions may be exaggerated for clarity.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

As used herein, the singular forms "a," "an," and "the" are intended to include the plural forms as well, unless the context clearly indicates otherwise.

It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As used herein, the terms "use," "using," and "used" may be considered synonymous with the terms "utilize," "utilizing," and "utilized," respectively.

As used herein, expressions such as "at least one of", "one of", and "selected from", when preceding a list of elements, modify the entire list of elements and do not modify the individual elements of the list. For example, "at least one selected from among a, b and c", "at least one of a, b or c", and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

As used herein, the term "and/or" includes any and all combinations of one or more of the associated listed items. Further, the use of "may" when describing embodiments of the present invention refers to "one or more embodiments of the present invention".

It will be understood that when an element is referred to as being "on," "connected to," or "coupled to" another element, it may be directly on, connected, or coupled to the other element or one or more intervening elements may also be present. When an element is referred to as being "directly on," "directly connected to," or "directly coupled to" another element, there are no intervening elements present.

Spatially relative terms, such as "beneath," "below," "lower," "above," "upper," "bottom," "top" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Further, in this specification, the phrase "on a plane," or "plan view," means viewing a target portion from the top, and the phrase "on a cross-section" means viewing a cross-section formed by vertically cutting a target portion from the side.

As used herein, the terms "substantially", "about", and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The electronic device and/or any other relevant devices or components according to embodiments of the present invention described herein may be implemented utilizing any suitable hardware, firmware (e.g. an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

Features of each of the embodiments of the present invention may be partially or entirely combined with each other and may technically variously interwork with each other, and respective embodiments may be implemented independently of each other or may be implemented together in association with each other.

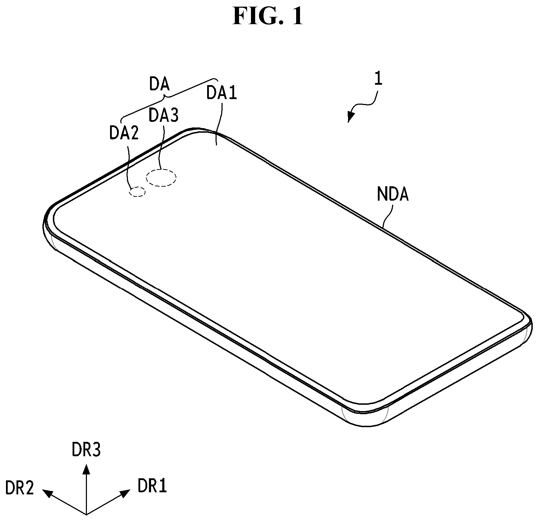

FIG. 1 is a perspective view showing an electronic device according to one or more embodiments.

Referring to FIG. 1, an electronic device 1 may display a moving image and/or a still image. The electronic device 1 may refer to any suitable electronic device providing (e.g., including) a display screen. Examples of the electronic device 1 may include a television, a laptop computer, a monitor, a billboard, an Internet-of-Things device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder and/or the like, which provide a display screen.

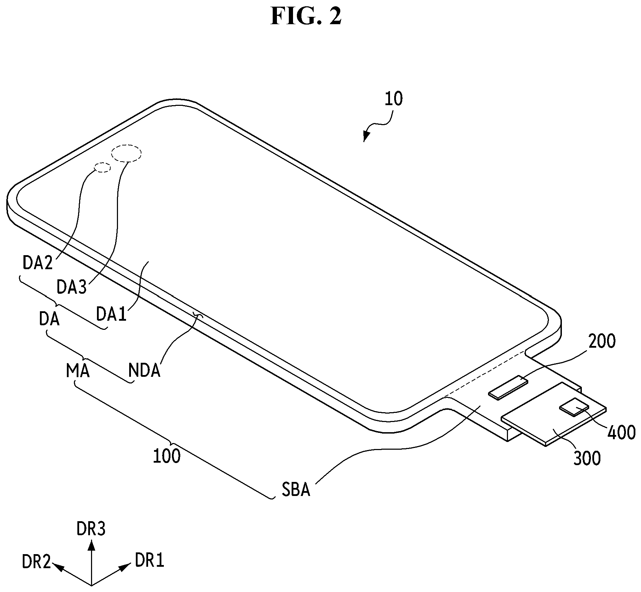

The electronic device 1 may include a display device (e.g., a display device 10 of FIG. 2) that provides a display screen. In one or more embodiments, the display device may be a light emitting display device including a light emitting element such as an inorganic light emitting diode or an organic light emitting diode, but the present invention is not limited thereto. For example, although a light emitting display device including an organic light emitting diode is described as a display device to which embodiments may be applied, devices and/or fields to which embodiments may be applied are not limited thereto. For example, embodiments may also be applied to other types (kinds) of display devices.

The shape of the electronic device 1 may be variously suitably modified. For example, the electronic device 1 may have a shape such as a rectangular shape elongated in a horizontal direction, a rectangular shape elongated in a vertical direction, a square shape, a substantially quadrilateral shape with rounded corners, other polygonal shapes and/or a circular shape. In one or more embodiments, the shape of a display area DA of the electronic device 1 may be similar to the overall shape of the electronic device 1, but the present invention is not limited thereto. In FIG. 1, the electronic device 1 having a rectangular shape that is longer in a second direction DR2 than in a first direction DR1 is exemplified.

The electronic device 1 may include the display area DA and a non-display area NDA. The display area DA is an area where an image can be displayed, and the non-display area NDA is an area where an image is not displayed. The display area DA may be referred to as an active region, and the non-display area NDA may be referred to as a non-active region. The display area DA may substantially occupy the center of the electronic device 1.

The display area DA may include a first display area DA1, a second display area DA2, and a third display area DA3. The second display area DA2 and the third display area DA3 are areas in which components for adding one or more suitable functions to the electronic device 1 are arranged, and the second display area DA2 and the third display area DA3 may correspond to a component area. Although FIG. 1 shows an embodiment in which the electronic device 1 includes two component areas, the number or location of the component areas is not limited. The first display area DA1 may be an area of the display area DA where no component is arranged. As used here, "component" may refer to, for example, a camera, a sensor, a speaker, or the like, but is not limited thereto.

FIG. 2 is a perspective view illustrating a display device included in an electronic device according to one or more embodiments.

Referring to FIGs. 1 and 2, the electronic device 1 according to one or more embodiments may include the display device 10. The display device 10 may provide (e.g., may be) a screen of the electronic device 1. The display device 10 may have a planar shape similar to the shape of the electronic device 1. For example, the display device 10 may have a shape similar to a rectangular shape having a short side in the first direction DR1 and a long side in the second direction DR2. The edge where the short side in the first direction DR1 and the long side in the second direction DR2 meet may be rounded, but the present invention is not limited thereto and the edge may be formed at a right angle. The planar shape of the display device 10 is not limited to a quadrilateral shape, and may have another suitable polygonal shape, a circular shape, an elliptical shape, or another suitable shape.

The display device 10 may include a display panel 100, a display driver 200, a circuit board 300, and a touch driver 400.

The display panel 100 may include a main region MA and a sub-region SBA.

The main region MA may include the display area DA including pixels displaying an image and the non-display area NDA arranged around the display area DA. The display area DA may be arranged substantially in the center of the main region MA, and the non-display area NDA may be around (e.g., may surround) the display area DA.

The display area DA may include the first display area DA1, the second display area DA2, and the third display area DA3. The display area DA may include emission areas of the pixels, and light may be emitted from the emission areas.

The display panel 100 may include circuit elements constituting pixel circuits of the pixels, light emitting elements electrically connected to the circuit elements, and a pixel defining layer around (e.g., surrounding) the emission areas of the pixels. The light emitting element of each of the pixels may be arranged in the emission area of the corresponding pixel. In one or more embodiments, the light emitting element may include one selected from among an organic light emitting diode (LED) including an organic light emitting layer, a quantum dot LED including a quantum dot light emitting layer, an inorganic LED including an inorganic semiconductor, and an ultra-small light emitting diode such as a micro LED or nano LED, but the present invention is not limited thereto.

The non-display area NDA may be an area outside the display area DA. For example, the non-display area NDA may be an edge area of the main region MA (e.g., the non-display area NDA may abut the peripheral circumference of the main region MA). In one or more embodiments, the non-display area NDA may include a gate driver that supplies gate signals to the gate lines, and fan-out lines that connect the display driver 200 to the display area DA.

The sub-region SBA may be a region extending from one side of the main region MA. The sub-region SBA may have flexible characteristics so it can be bent, folded, and/or rolled. In one or more embodiments, when the sub-region SBA is bent (and/or folded), the sub-region SBA may overlap the main region MA in a thickness direction (e.g., a third direction DR3). For example, when the display device 10 is bent in the sub-region SBA, at least a part of the sub-region SBA including an area where the display driver 200 is arranged and an area where a pad portion connected to the circuit board 300 is arranged may be positioned under the main region MA.

The sub-region SBA may include the display driver 200 and the pad portion electrically connected to the circuit board 300. In some embodiments, the sub-region SBA may not be provided, and the display driver 200 and the pad portion may be arranged in the non-display area NDA of the main region MA. In some embodiments, the display driver 200 may be arranged on the circuit board 300 connected to the display panel 100, and may be electrically connected to the display panel 100 through the pad portion.

The display driver 200 may output driving signals and driving voltages for driving the display panel 100. For example, the display driver 200 may supply data voltages to data lines, supply driving voltages (e.g., first pixel voltage (or anode voltage) and second pixel voltage (or cathode voltage)) to power lines, and supply gate control signals to the gate driver. In one or more embodiments, the display driver 200 may be formed as an integrated circuit (IC) and mounted on the display panel 100 by a chip on glass (COG) method, a chip on plastic (COP) method, and/or an ultrasonic bonding method.

The circuit board 300 may be attached to the pad portion of the display panel 100 by using an anisotropic conductive film (ACF) and/or the like. Lead lines of the circuit board 300 may be electrically connected to the pad portion of the display panel 100. In one or more embodiments, the circuit board 300 may be a flexible printed circuit board, a printed circuit board, and/or a flexible film such as a chip on film.

The touch driver 400 may be mounted on the circuit board 300. The touch driver 400 may be connected (e.g., physically and/or electrically connected) to a touch sensing layer of the display panel 100. The touch driver 400 may supply each touch drive signal to touch electrodes of the touch sensing layer, and may sense the amount of change in capacitance formed between the touch electrodes. In one or more embodiments, the touch driving signal may be a pulse signal having a set or predetermined frequency. The touch driver 400 may detect whether or not a touch input has occurred and coordinates of the input based on the amount of change in capacitance between the touch electrodes. In one or more embodiments, the touch driver 400 may be formed as an integrated circuit (IC).

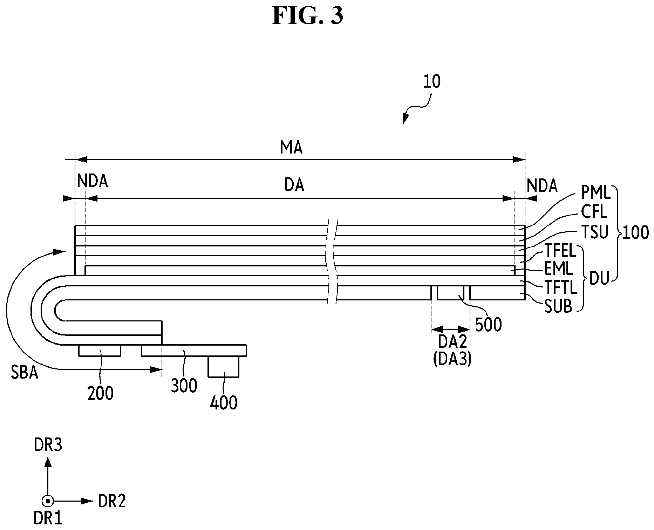

FIG. 3 is a cross-sectional view of the display device of FIG. 2 viewed from the side (e.g., a cross-section may be taken along the second direction DR2 in FIG. 2). FIG. 3 illustrates the sub-region SBA of the display panel 100 in a bent state in the display device 10 of FIG. 2.

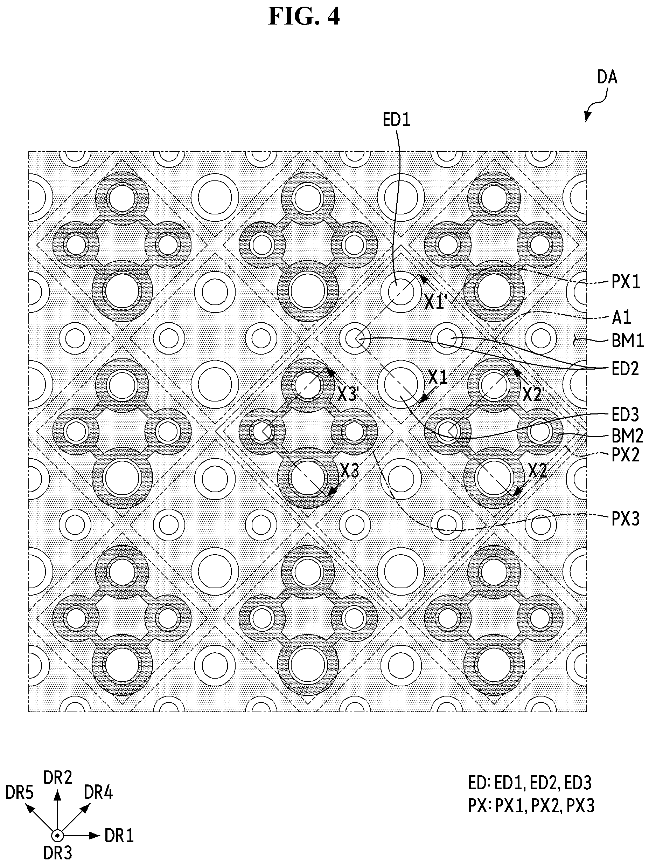

Referring to FIG. 3, the display panel 100 may include a display layer DU, a touch sensing layer TSU, a color filter layer CFL, and a light blocking member layer PML. Although the color filter layer CFL and the light blocking member layer PML are separately illustrated in FIG. 3, embodiments are not limited thereto. For example, an element (e.g., a second light blocking layer BM2 of FIG. 4) included in the light blocking member layer PML, which is an element arranged in the color filter layer CFL, may be considered as an element arranged at a higher portion among the elements of the color filter layer CFL.

The display layer DU may include a substrate SUB, a thin film transistor layer TFTL, a light emitting element layer EML, and an encapsulation layer TFEL.

The substrate SUB may be a base substrate and/or a base member. The substrate SUB may be a flexible substrate which can be bent, folded and/or rolled, but the present invention is not limited thereto. In one or more embodiments, the substrate SUB may include a polymer resin such as polyimide (PI). In some embodiments, the substrate SUB may include a glass material and/or a metal material.

The thin film transistor layer TFTL may be arranged on the substrate SUB. The thin film transistor layer TFTL may include circuit elements, e.g., thin film transistors and capacitors, constituting pixel circuits of pixels. The thin film transistor layer TFTL may further include wires. For example, the thin film transistor layer TFTL may further include gate lines, data lines, power lines, gate control lines, fan-out lines that connect the display driver 200 to the data lines, and/or lead lines that connect the display driver 200 to the pad portion. Each of the thin film transistors may include a semiconductor region, a source electrode, a drain electrode, and a gate electrode. In one or more embodiments, when the display panel 100 includes the gate driver arranged in the non-display area NDA, the thin film transistor layer TFTL may further include circuit elements constituting the gate driver.

The thin film transistor layer TFTL may be arranged in the display area DA, the non-display area NDA, and the sub-region SBA. The circuit elements constituting the pixel circuits of the pixels, and the gate lines, the data lines, and the power lines that are electrically connected to the pixels may be arranged in the display area DA of the thin film transistor layer TFTL. The gate lines, the data lines, and the power lines may extend to the non-display area NDA of the thin film transistor layer TFTL, and may be respectively electrically connected to the gate driver, the display driver 200, and/or the pad portion. The gate control lines and the fan-out lines may be arranged in the non-display area NDA of the thin film transistor layer TFTL. The lead lines may be arranged in the sub-region SBA of the thin film transistor layer TFTL.

The light emitting element layer EML may be arranged on the thin film transistor layer TFTL. The light emitting element layer EML may include a pixel defining layer that defines emission areas (or light emitting element areas) of pixels, and light emitting elements arranged in the emission areas. Each emission area may be arranged in each pixel area of the display area DA. For example, the pixel area where the respective pixels of the display area DA are arranged may include a pixel circuit area where circuit elements constituting the pixel circuit of the corresponding pixel are arranged and an emission area where the light emitting element of the corresponding pixel is arranged. In one or more embodiments, the emission area and the pixel circuit area of each pixel may overlap each other in the third direction DR3. In one or more embodiments, each pixel may include a plurality of sub-pixels, and may include the plurality of pixel circuits and the plurality of light emitting elements forming the plurality of sub-pixels.

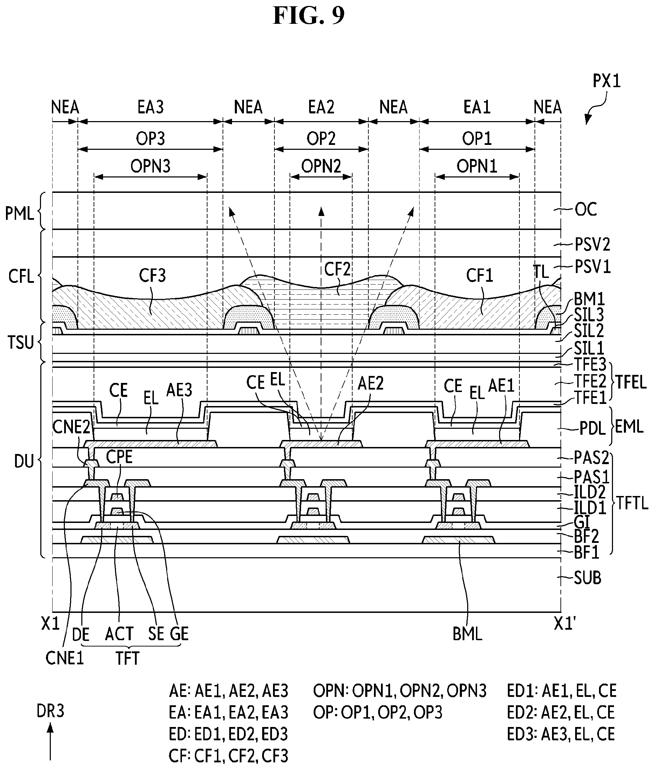

The light emitting element may include a first electrode and a second electrode facing each other, and a light emitting layer interposed between the first electrode and the second electrode. In one or more embodiments, the first electrode of the light emitting element may correspond to the pixel electrode shown in FIG. 4 and subsequent drawings, and the second electrode of the light emitting element may correspond to the common electrode shown in FIG. 9 and subsequent drawings. In one or more embodiments, the light emitting layer may be an organic light emitting layer including an organic material. The light emitting layer may include a hole transporting layer, an organic light emitting layer, and an electron transporting layer. When a first pixel voltage (e.g., anode voltage) is applied to the first electrode of the light emitting element through at least one selected from among the thin film transistors of each pixel circuit and a second pixel voltage (e.g., cathode voltage) is applied to the second electrode of the light emitting element through the power line, holes and electrons may recombine in an organic light emitting layer and the light emitting element may be to emit light. In one or more embodiments, the light emitting element may be another type or kind of light emitting element, such as a quantum dot light emitting diode including a quantum dot light emitting layer, an inorganic light emitting diode including an inorganic semiconductor, a micro light emitting diode, and/or a nano light emitting diode.

The encapsulation layer TFEL may cover the top surface and the side surface of the light emitting element layer EML, and may protect the light emitting element layer EML. In one or more embodiments, the encapsulation layer TFEL may include at least one inorganic film and at least one organic film for encapsulating the light emitting element layer EML. For example, the encapsulation layer TFEL may include a plurality of inorganic films and an organic film interposed between the inorganic films.

The touch sensing layer TSU may be arranged on the display layer DU. For example, the touch sensing layer TSU may be arranged or formed on the encapsulation layer TFEL, or may be arranged on a separate substrate arranged on the display layer DU.

The touch sensing layer TSU may include touch electrodes for sensing the user's touch input, and wires that electrically connect the touch electrodes to the touch driver 400. In one or more embodiments, the touch sensing layer TSU may sense the user's touch in a mutual capacitance manner and/or a self-capacitance manner, and the touch electrodes may have a shape for constituting a mutual capacitance type or kind and/or self-capacitance type or kind touch sensor.

The touch electrodes of the touch sensing layer TSU may be arranged in a touch sensor area overlapping the display area DA. The area in the display area DA where the touch electrodes are arranged may be the touch sensor area. For example, the touch sensor area may be all or a part of the display area DA. Wires electrically connected to the touch electrodes of the touch sensing layer TSU may be arranged in a peripheral area overlapping the non-display area NDA.

The color filter layer CFL may be arranged on the touch sensing layer TSU. The color filter layer CFL may include color filters corresponding to the respective emission areas of the pixels. Each of the color filters may selectively transmit light of a set or specific color or wavelength and may block, reduce or absorb light of a different color or wavelength. In one or more embodiments, the color filter layer CFL may further include a first light blocking layer (or first light blocking patterns forming the first light blocking layer) around (e.g., surrounding) the emission areas of the pixels. The first light blocking layer may be formed separately (e.g., spaced and/or apart) from the color filters by using a separate light blocking material (e.g., a light absorbing material), or may be formed by overlapping a plurality of color filters that selectively transmit lights of different wavelengths.

The color filter layer CFL may be to absorb a part of light coming from the outside of the display device 10 to reduce reflected light due to external light. The distortion of color due to reflection of external light may be prevented or reduced by the color filter layer CFL.

In one or more embodiments, the color filter layer CFL may be arranged directly on the touch sensing layer TSU. Accordingly, the display device 10 may not include (e.g., may exclude) a separate substrate for the color filter layer CFL, and may have a further reduced thickness.

The light blocking member layer PML may be arranged on the color filter layer CFL. The light blocking member layer PML may include a second light blocking layer (or second light blocking patterns forming the second light blocking layer) arranged to correspond to some pixels of the display layer DU. In one or more embodiments, the light blocking member layer PML may include the second light blocking layer that surrounds the light emitting elements arranged in the emission areas of some pixels, in proximity to the emission areas and/or the light emitting elements in plan view.

The light blocking member layer PML may limit the viewing angle of the image displayed by some pixels. For example, the display device 10 includes the light blocking member layer PML and thus may control visibility at a set or specific viewing angle and provide a side viewing angle limiting mode, such as a privacy protection mode, to a user.

In some embodiments, the display device 10 may further include an optical device 500 arranged in a component area (e.g., the second display area DA2 and/or the third display area DA3 of FIGS. 1 and 2). The optical device 500 may be to emit or receive light in infrared, ultraviolet, and/or visible light bands. For example, the optical device 500 may be an optical sensor that detects light incident on the display device 10 such as a proximity sensor, an illuminance sensor, and/or a camera sensor and/or an image sensor.

FIG. 4 is a plan view illustrating a display area of a display device according to one or more embodiments. For example, FIG. 4 shows light emitting elements ED arranged in the display area DA of the display device 10 according to one or more embodiments and a first light blocking layer BM1 and a second light blocking layer BM2 arranged around the light emitting elements ED.

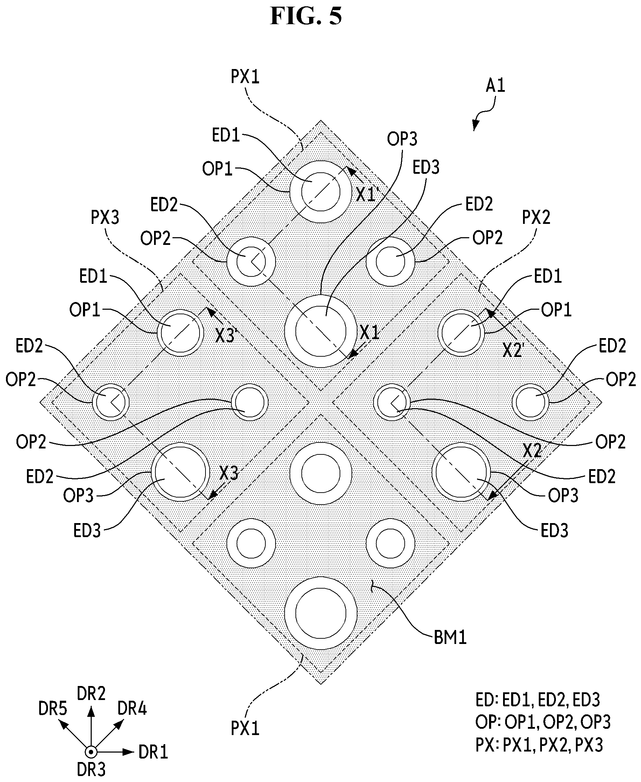

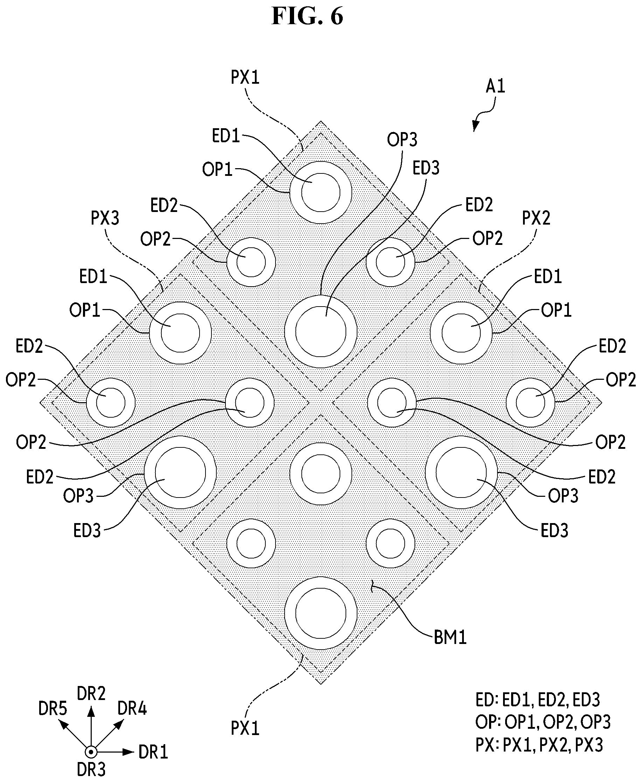

FIG. 5 is a plan view showing light emitting elements and a first light blocking layer according to one or more embodiments. FIG. 6 is a plan view showing light emitting elements and a first light blocking layer according to one or more embodiments. For example, FIG. 5 illustrates the light emitting elements ED and the first light blocking layer BM1 arranged in area A1 of FIG. 4, and FIG. 6 illustrates another embodiment of the first light blocking layer BM1 of FIG. 5.

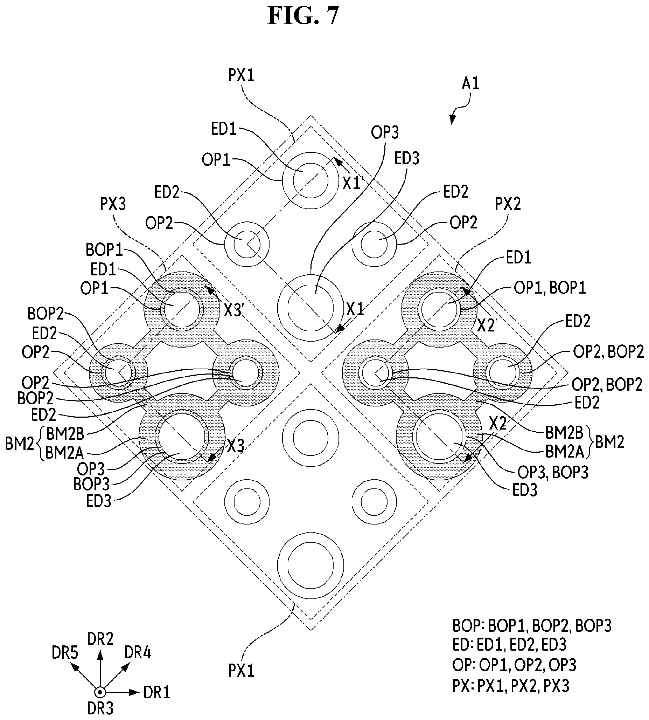

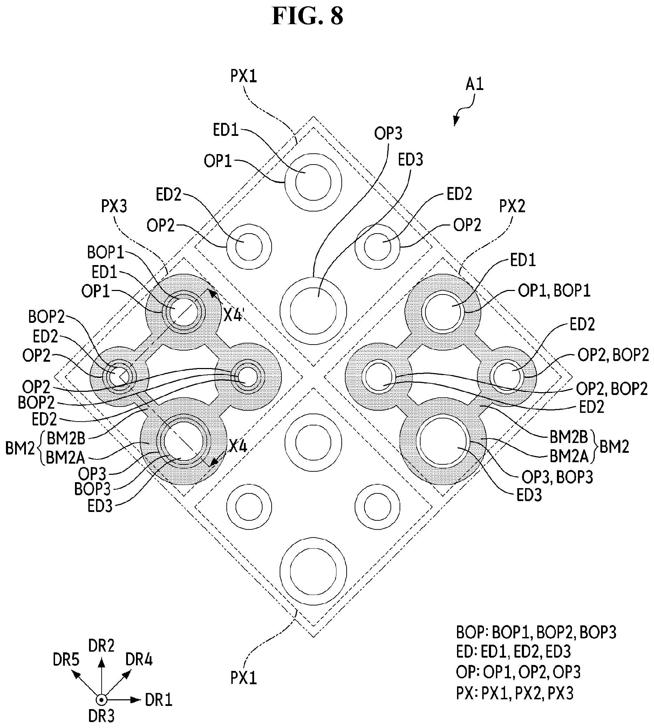

FIG. 7 is a plan view showing light emitting elements and a second light blocking layer according to one or more embodiments. FIG. 8 is a plan view showing light emitting elements and a second light blocking layer according to one or more embodiments. For example, FIG. 7 illustrates the light emitting elements ED and the second light blocking layer BM2 arranged in area A1 of FIG. 4, and FIG. 8 illustrates another embodiment of the second light blocking layer BM2 of FIG. 7. In FIGS. 7 and 8, the positions of openings OP of the first light blocking layer BM1 are also indicated to more clearly show the position of the second light blocking layer BM2.

Referring to FIGS. 4 to 8, the display device 10 may include the pixels PX arranged in the display area DA. In one or more embodiments, the pixels PX may be arranged in a fourth direction DR4 and a fifth direction DR5 each between the first direction DR1 and the second direction DR2. In one or more embodiments, the fourth direction DR4 and the fifth direction DR5 may each be a diagonal direction with respect to the first direction DR1 and the second direction DR2. However, the arrangement and/or direction of the pixels PX may be variously suitably changed depending on embodiments.

The display area DA may include the emission areas in which the light emitting elements ED of the pixels PX are arranged, and a non-emission area around (e.g., surrounding) the emission areas. Each pixel PX, or each pixel area in which each pixel PX is arranged, may include the plurality of emission areas in which the plurality of light emitting elements ED are arranged, and the non-emission area around (e.g., surrounding) the emission areas.

In describing embodiments, the area (e.g., a light transmitting area through which light generated from the light emitting elements ED is to be emitted) that includes the light emitting element areas in which the respective light emitting elements ED are arranged, and where the light emitting elements ED are exposed through the openings OP of the first light blocking layer BM1 is defined as the emission area. Further, as the remaining area excluding the emission areas in each pixel area and/or the display area DA, the area (e.g., a light blocking area in which the first light blocking layer BM1 is arranged) covered by the first light blocking layer BM1 in plan view is defined as the non-emission area. However, the criteria for distinguishing between the emission areas and the non-emission area may vary. In one or more embodiments, areas where the pixel electrodes (e.g., pixel electrodes AE in FIGS. 9 to 12) are exposed through openings (e.g., openings OPN of a pixel defining layer PDL in FIGS. 9 to 12) of the pixel defining layer that define the light emitting element areas may be defined as emission areas EA. In one or more embodiments, in consideration of both the light blocking areas by the first light blocking layer BM1 and the second light blocking layer BM2, in a first pixel PX1 where the second light blocking layer BM2 is not arranged, the emission area and the non-emission area may be distinguished based on the first light blocking layer BM1, and in a second pixel PX2 where the second light blocking layer BM2 is arranged, the emission area and the non-emission area may be distinguished based on the first light blocking layer BM1 and the second light blocking layer BM2. For example, in the first pixel PX1, the light transmitting areas where the light emitting elements ED are exposed through the openings OP of the first light blocking layer BM1 may be defined as the emission areas, and the area where the first light blocking layer BM1 is arranged may be defined as the non-emission area. Additionally, in the second pixel PX2 and the third pixel PX3, the light transmitting areas where the openings OP of the first light blocking layer BM1 and openings BOP of the second light blocking layer BM2 overlap may be defined as the emission areas, and the area where at least one selected from among the first light blocking layer BM1 and the second light blocking layer BM2 is arranged may be defined as the non-emission area.

In FIGS. 4 to 8, each light emitting element ED may be depicted as an area in which the light emitting element ED is arranged or formed based on the pixel electrode included in the light emitting element ED. For example, in FIGS. 4 to 8, the area where the light emitting element ED is formed by providing the common electrode and the light emitting layer of the light emitting element ED on a portion where the pixel electrode of the light emitting element ED is exposed through the opening of the pixel defining layer may be depicted in the form of the light emitting element ED.

In one or more embodiments, each pixel PX may include the plurality of light emitting elements ED that may emit lights of different colors. For example, each pixel PX may include a first light emitting element ED1, a second light emitting element ED2, and a third light emitting element ED3. The first light emitting element ED1 may be to emit light of a first color (e.g., red light). The second light emitting element ED2 may be to emit light of a second color (e.g., green light). The third light emitting element ED3 may be to emit light of a third color (e.g., blue light). Accordingly, the pixel PX may be to emit light of one or more suitable colors that can be represented by at least one selected from among the first color light, the second color light, and the third color light. In one or more embodiments, each pixel PX may include one first light emitting element ED1, two second light emitting elements ED2, and one third light emitting element ED3. However, the embodiments are not limited thereto, and the number, type (or kind), and/or ratio of the light emitting elements ED arranged in one pixel PX may vary according to one or more embodiments.

In one or more embodiments, each pixel PX may include the plurality of sub-pixels including the respective light emitting elements ED. For example, each pixel PX may include a first sub-pixel including the first light emitting element ED1, a second sub-pixel (e.g., two second sub-pixels) including the second light emitting element ED2, and a third sub-pixel including the third light emitting element ED3. In one or more embodiments, each sub-pixel may further include a pixel circuit electrically connected to each light emitting element ED.

In one or more embodiment, the light emitting elements ED may have a circular shape. According to one embodiment, more than one light emitting elements ED may be arranged in one pixel PX, in particular, four light emitting elements ED may be arranged in one pixel PX. The light emitting elements ED may have circular shapes with at least two different diameters. The light emitting elements ED may be arranged in corner portions of the pixel PX.

In one or more embodiments, the light emitting elements ED may be arranged in a Pentile^{®} (PENTILE^{®} is a registered trademark owned by Samsung Display Co., Ltd.) type or kind, e.g., a diamond PENTILE^{®} type or kind. For example, the first light emitting elements ED1 and the third light emitting elements ED3 may be spaced apart from each other in the second direction DR2, and may be arranged alternately with each other along the first direction DR1 and the second direction DR2. In each pixel PX, the first light emitting element ED1 and the third light emitting element ED3 may be spaced apart from each other in the second direction DR2, and may be spaced apart from the second light emitting elements ED2 in the fourth direction DR4 and/or the fifth direction DR5. The second light emitting elements ED2 may be repeatedly arranged with each other along the first direction DR1 and the second direction DR2. The first light emitting elements ED1 and the second light emitting elements ED2 may be alternately arranged along the fourth direction DR4 and/or the fifth direction DR5, and the second light emitting elements ED2 and the third light emitting elements ED3 may be alternately arranged along the fourth direction DR4 and/or the fifth direction DR5. However, embodiments are not limited thereto, and the arrangement of the light emitting elements ED may be variously suitably changed.

In one or more embodiments, the first light emitting element ED1 (or a first pixel electrode of the first light emitting element ED1), the second light emitting element ED2 (or a second pixel electrode of the second light emitting element ED2), and the third light emitting element ED3 (or a third pixel electrode of the third light emitting element ED3) may have different sizes. For example, the size of the third light emitting element ED3 may be greater than the sizes of each of the first light emitting element ED1 and the second light emitting element ED2, and the size of the first light emitting element ED1 may be greater than the size of the second light emitting element ED2. In describing embodiments, the size of a specific element may include at least one selected from among width (e.g., width in at least one direction in plan view or cross-sectional view) and area (e.g., area in plan view). For example, when comparing the sizes of specific elements, the relative size may be compared based on at least one selected from among width and area. As used herein, "width" may refer to a diameter, if the corresponding element has a circular cross-section and/or may refer to a major axis length and/or a minor axis length, if the corresponding element has an oval or elongated cross-section.

Depending on the size of the light emitting element ED and/or the size of the emission area in which the light emitting element ED is arranged, the intensity of light emitted from each emission area may vary. Therefore, by adjusting the sizes of each light emitting element ED and the emission area including it, the color displayed on the screen of the display device 10 and/or the electronic device 1 may be controlled or selected. Although FIGS. 4 to 8 show an embodiment in which the third light emitting element ED3 has the largest size, embodiments are not limited thereto. For example, the sizes, e.g., the areas, of the light emitting element ED and the emission area including it may be variously suitably adjusted depending on the color desired or required for the screen of the display device 10. In one or more embodiments, the size of the light emitting element ED and the emission area may be related to (e.g., may affect) light efficiency, the lifespan of the light emitting element ED, and/or the like, and may have a trade-off relation with the reflection by external light (e.g., the larger the size of the light emitting element ED and the emission area, the more external light may be reflected). The size and ratio of the light emitting elements ED may be appropriately or suitably adjusted in consideration of the above factors.

In one or more embodiments, the sizes of the light emitting elements ED of the pixels PX may be substantially uniform. For example, the sizes of the first light emitting elements ED1 included in the first pixels PX1, the second pixels PX2, and the third pixels PX3 may be substantially the same. In one or more embodiments, the sizes of the openings in the pixel defining layer that expose the first pixel electrode of each of the first pixels PX1, the first pixel electrode of each of the second pixels PX2, and the first pixel electrode of each of the third pixels PX3 (e.g., the sizes of first openings OPN1 of the pixel defining layer PDL shown in FIGS. 9 to 12, and/or the aperture ratios of the pixel defining layer PDL corresponding to first emission areas EA1 of the pixels PX) may be substantially the same. In some embodiments, the sizes of the second light emitting elements ED2 included in the first pixels PX1, the second pixels PX2, and the third pixels PX3 may be substantially the same, and the sizes of the third light emitting elements ED3 included in the first pixels PX1, the second pixels PX2, and the third pixels PX3 may be substantially the same.

The emission areas in which the light emitting elements ED are arranged may be surrounded by the first light blocking layer BM1. For example, the light emitting elements ED may be surrounded by the first light blocking layer BM1 in plan view.

The first light blocking layer BM1 may be entirely arranged in the display area DA, and may include the openings OP that expose the light emitting elements ED of the pixels PX. For example, as shown in FIGS. 5 and 6, in plan view, the first light blocking layer BM1 may include first openings OP1 that expose the first light emitting elements ED1, second openings OP2 that expose the second light emitting elements ED2, and third openings OP3 that expose the third light emitting elements ED3, and may be around (e.g., may surround) the first light emitting elements ED1, the second light emitting elements ED2, and the third light emitting elements ED3. The first light blocking layer BM1 may be arranged in the non-emission area of (e.g., corresponding to) all pixels PX in the display area DA including the first pixels PX1, the second pixels PX2, and the third pixels PX3. Accordingly, it is possible to uniformly (e.g., substantially uniformly) reduce reflected light caused by external light in the display area DA, and reduce light interference between adjacent pixels PX.

In one or more embodiments, the openings OP of the first light blocking layer BM1 may correspond to the respective emission areas. For example, the first openings OP1, the second openings OP2, and the third openings OP3 of the first light blocking layer BM1 may correspond to first emission areas, second emission areas, and third emission areas, respectively, in which the first light emitting elements ED1, the second light emitting elements ED2, and the third light emitting elements ED3 are respectively arranged. The first light blocking layer BM1 may cover other portions, e.g., the non-emission area, in the display area DA excluding the emission areas.

In one or more embodiment, the openings OP may have a circular shape. According to one embodiment, more than one openings OP may be arranged in one pixel PX, in particular, four openings OP may be arranged in one pixel PX. The openings OP may have circular shapes with at least two different diameters. openings OP may be arranged in corner portions of the pixel PX.

Each of the openings OP of the first light blocking layer BM1 may be greater (e.g., larger) than each light emitting element ED (or a part of the pixel electrode exposed by the opening of the pixel defining layer) in plan view. For example, the size of the first opening OP1 of the first light blocking layer BM1 may be larger than the size of the first light emitting element ED1, the size of the second opening OP2 of the first light blocking layer BM1 may be larger than the size of the second light emitting element ED2, and the size of the third opening OP3 of the first light blocking layer BM1 may be larger than the size of the third light emitting element ED3. In one or more embodiments, the first light blocking layer BM1 may surround the light emitting elements ED at a position spaced apart (e.g., while being spaced apart) from the light emitting elements ED in plan view.

In one or more embodiments, the sizes of the openings OP of the first light blocking layer BM1 may correspond to the sizes of the respective light emitting elements ED (or the emission areas in which the light emitting elements ED are arranged). For example, the size of the first opening OP1, the size of the second opening OP2, and the size of the third opening OP3 in the first light blocking layer BM1 may correspond to the size of the first light emitting element ED1, the size of the second light emitting element ED2, and the size of the third light emitting element ED3, respectively. In one or more embodiments, the size of the second opening OP2 of the first light blocking layer BM1 may be smaller than the size of each of the first opening OP1 and the third opening OP3 of the first light blocking layer BM1, and the size of the third opening OP3 of the first light blocking layer BM1 may be larger than the size of each of the first opening OP1 and the second opening OP2 of the first light blocking layer BM1.

In one or more embodiments, the display area DA may include at least three types (kinds) of pixels PX. For example, the display area DA may include first pixels PX1, second pixels PX2, and third pixels PX3.

The light exit angles and/or viewing angles of the first pixels PX1, the second pixels PX2, and the third pixels PX3 may be different. For example, the first pixels PX1 may provide the widest range of light exit angles and/or viewing angles, the second pixels PX2 may provide a medium range of light exit angles and/or viewing angles, and the third pixels PX3 may provide the narrowest range of light exit angles and/or viewing angles.

In one or more embodiments, approximately half of the total pixels PX in the display area DA may be the first pixels PX1, while the remaining pixels PX may be the second pixels PX2 and the third pixels PX3. In one or more embodiments, the number or ratio of the second pixels PX2 and the third pixels PX3 may be substantially the same. For example, the second pixels PX2 and the third pixels PX3 may each correspond to approximately one-quarter of the total pixels PX in the display area DA. However, the embodiments are not limited thereto, and the number or ratio of the first pixels PX1, the second pixels PX2, and the third pixels PX3 may be variously suitably changed according to one or more embodiments.

In one or more embodiments, the first pixels PX1, the second pixels PX2, and the third pixels PX3 may be uniformly (e.g., substantially uniformly) distributed in the display area DA. For example, the first pixels PX1, the second pixels PX2, and the third pixels PX3 may be alternately arranged and uniformly (e.g., substantially uniformly) distributed in the entire display area DA.

In one or more embodiments, the first pixels PX1 may be repeatedly arranged with each other along the first direction DR1 and the second direction DR2, and the second pixels PX2 and the third pixels PX3 may be arranged alternately with each other along the first direction DR1 and the second direction DR2 in the display area DA. The first pixels PX1 and the second pixels PX2 may be alternately arranged along the fourth direction DR4 and the fifth direction DR5 in the display area DA. The first pixels PX1 and the third pixels PX3 may be alternately arranged along the fourth direction DR4 and the fifth direction DR5 in the display area DA. However, the embodiments are not limited thereto, and the arrangement of the first pixels PX1, the second pixels PX2, and the third pixels PX3 may be variously suitably changed according to one or more embodiments.

In one or more embodiments, the light exit angles, side light emission ratios, and/or viewing angles of the first pixels PX1, the second pixels PX2, and the third pixels PX3 may be differentiated by using at least one selected from among the first light blocking layer BM1 and the second light blocking layer BM2. For example, the first pixels PX1, the second pixels PX2, and the third pixels PX3 may have different structures with respect to at least one selected from among the first light blocking layer BM1 and the second light blocking layer BM2.

In the first pixels PX1, the second pixels PX2, and the third pixels PX3, the size, aperture ratio, and/or opening area of the first light blocking layer BM1 may be the same or different.

In one or more embodiments, as shown in FIG. 5, in the second pixels PX2 and the third pixels PX3, the first light blocking layer BM1 may be opened in a size different from the size in the first pixels PX1. In other words, the size of the openings of the first light blocking layer BM1 may differ between the first pixels PX1 and the second and third pixels PX2 and PX3. For example, the first light blocking layer BM1 may include the openings OP having a relatively large size in the first pixels PX1, and the openings OP having a relatively small size in the second pixels PX2 and the third pixels PX3. In this case, the first light blocking layer BM1 may surround the light emitting elements ED at a closer distance in the second pixels PX2 and the third pixels PX3 compared to the first pixels PX1. For example, in plan view, the separation distance (or the size of the openings OP of the first light blocking layer BM1 that expose the emission areas of the first pixels PX1) between the first light blocking layer BM1 (e.g., the inner circumference of the corresponding opening OP) and the light emitting elements ED in the first pixels PX1 may be greater than each of the separation distance (or the size of the openings OP of the first light blocking layer BM1 that expose the emission areas of the second pixels PX2) between the first light blocking layer BM1 (e.g., the inner circumference of the corresponding opening OP) and the light emitting elements ED in the second pixels PX2, and the separation distance (or the size of the openings OP of the first light blocking layer BM1 that expose the emission areas of the third pixels PX3) between the first light blocking layer BM1 (e.g., the inner circumference of the corresponding opening OP) and the light emitting elements ED in the third pixels PX3. In the second pixels PX2 and the third pixels PX3, the first light blocking layer BM1 may be opened in a substantially uniform size, but the embodiments are not limited thereto.

As the first light blocking layer BM1 surrounds the light emitting elements ED of the second pixels PX2 and the third pixels PX3 at a closer distance (e.g., at a lesser separation distance), the size (e.g., the effective light emitting area) of the emission areas of the second pixels PX2 and the third pixels PX3 may be reduced compared to the size of the emission areas of the first pixels PX1. Accordingly, the light exit angle and/or viewing angle of the second pixels PX2 and the third pixels PX3 may be narrower than the light exit angle and/or viewing angle of the first pixels PX1. In one or more embodiments, the light exit angle and/or viewing angle of the second pixels PX2 and the third pixels PX3 may also be controlled or selected (e.g., limited) by the second light blocking layer BM2, in addition to the size and/or position of the openings OP of the first light blocking layer BM1.

In some embodiments, as shown in FIG. 6, the first light blocking layer BM1 may be opened in a substantially uniform size in the first pixels PX1, the second pixels PX2, and the third pixels PX3. For example, the sizes of the first openings OP1 of the first light blocking layer BM1 that expose the first light emitting elements ED1 of the first pixels PX1, the second pixels PX2, and the third pixels PX3 may be substantially the same. Similarly, the sizes of the second openings OP2 of the first light blocking layer BM1 that expose the second light emitting elements ED2 of the first pixels PX1, the second pixels PX2, and the third pixels PX3 may be substantially the same, and the sizes of the third openings OP3 of the first light blocking layer BM1 that expose the third light emitting elements ED3 of the first pixels PX1, the second pixels PX2, and the third pixels PX3 may be substantially the same. In this case, the first light blocking layer BM1 may surround the light emitting elements ED of the first pixels PX1, the second pixels PX2, and the third pixels PX3 at a substantially uniform distance (e.g., a substantially uniform separation distance). Accordingly, the sizes of the emission areas of the first pixels PX1, the second pixels PX2, and the third pixels PX3 defined by the first light blocking layer BM1 may be substantially uniform. However, in the present embodiments, as the second light blocking layer BM2 is selectively and/or differentially arranged in the first pixel PX1, the second pixel PX2, and the third pixel PX3, the effective light emitting area, luminance, and/or viewing angle of the first pixel PX1, the second pixel PX2, and the third pixel PX3 may vary.

The second light blocking layer BM2 may be arranged only in some of the pixels PX arranged in the display area DA. For example, the second light blocking layer BM2 may not be arranged in the first pixels PX1, and may be arranged only in the second pixels PX2 and the third pixels PX3. In one or more embodiments, the second pixels PX2 and the third pixels PX3 may include the second light blocking layer BM2 that may be around (e.g., may surround) the light emitting element areas in which the light emitting elements ED are arranged. The second light blocking layer BM2 may surround the light emitting elements ED of the second pixels PX2 and the third pixels PX3 in plan view.

In one or more embodiments, the second light blocking layer BM2 may be arranged in a portion of the non-emission area of the second pixels PX2 and the third pixels PX3. For example, the second light blocking layer BM2 may be arranged on a portion of the first light blocking layer BM1 in the second pixels PX2 and the third pixels PX3. As the second light blocking layer BM2 is arranged on the first light blocking layer BM1, the light exit angle and/or viewing angle of the second pixels PX2 and the third pixels PX3 may be further adjusted and/or limited or reduced. For example, the light exit angle and/or viewing angle of the second pixels PX2 and the third pixels PX3 may be adjusted and/or changed by at least one selected from among the size of the openings BOP of the second light blocking layer BM2 and the separation distance between the second light blocking layer BM2 and the light emitting elements ED of the second pixels PX2.

As the second light blocking layer BM2 is arranged in the second pixels PX2 and the third pixels PX3, the side light of the second pixels PX2 and the third pixels PX3 may be blocked or substantially reduced. Accordingly, the light exit angle and/or viewing angle of the second pixels PX2 and the third pixels PX3 may be narrower than the light exit angle and/or viewing angle of the first pixels PX1.

In one or more embodiments, the separation distance between the second light blocking layer BM2 and the light emitting elements ED of the second pixels PX2 may be different from the separation distance between the second light blocking layer BM2 and the light emitting elements ED of the third pixels PX3. For example, the separation distance between the light emitting elements ED and the second light blocking layer BM2 arranged in each of the second pixels PX2 may be greater than the separation distance between the light emitting elements ED and the second light blocking layer BM2 arranged in each of the third pixels PX3. Accordingly, the light exit angle of the second pixels PX2 may be smaller than the light exit angle of the first pixels PX1 and larger than the light exit angle of the third pixels PX3.

The second light blocking layer BM2 may haye a ring shape. At least two second light blocking layer BM2 having a ring shape may be connected to each other by a connection portion. The connection portions connecting four second light blocking layer BM2 may form parts of a rectangle, see e.g. fig. 7.

In one or more embodiments, the second light blocking layer BM2 arranged in one second pixel PX2 and/or one third pixel PX3 may be formed as one pattern. In one or more embodiments, the second light blocking layer BM2 arranged in one second pixel PX2 may include ring portions BM2A that surround the first light emitting element ED1, the second light emitting elements ED2, and the third light emitting element ED3 of the second pixel PX2, and connection portions BM2B that connect the ring portions BM2A. Similarly, the second light blocking layer BM2 arranged in one third pixel PX3 may include ring portions BM2A that surround the first light emitting element ED1, the second light emitting elements ED2, and the third light emitting element ED3 of the third pixel PX3, and connection portions BM2B that connect the ring portions BM2A. However, the embodiments are not limited thereto, and the shape, number, and/or size of the second light blocking layer BM2 may vary according to one or more embodiments. In some embodiments, the second light blocking layer BM2 arranged in at least two adjacent pixels PX among the second pixels PX2 and the third pixels PX3 may be formed as one pattern.

The ring portions BM2A of the second light blocking layer BM2 may include the openings BOP that expose the respective light emitting elements ED, and may have a shape (e.g., a ring shape) around (e.g., surrounding) the light emitting elements ED. For example, the second light blocking layer BM2 of the second pixel PX2 may include a first opening BOP1, second openings BOP2, and a third opening BOP3 that expose the first light emitting element ED1, the second light emitting elements ED2, and the third light emitting element ED3 of the second pixel PX2, respectively, and the second light blocking layer BM2 of the third pixel PX3 may include the first opening BOP1, the second openings BOP2, and the third opening BOP3 that expose the first light emitting element ED1, the second light emitting elements ED2, and the third light emitting element ED3 of the third pixel PX3, respectively.

The connection portions BM2B of the second light blocking layer BM2 may be arranged between the ring portions BM2A, and may be formed integrally with the ring portions BM2A. Accordingly, in a pixel process for forming the pixels PX, deviation from a determined position and/or peeling off of the second light blocking layer BM2 may be prevented or reduced, and the second light blocking layer BM2 may be more stably or suitably formed.

In one or more embodiments, the second light blocking layer BM2 may have a shape corresponding to the shape of the light emitting elements ED (or the pixel electrodes of the light emitting elements ED) of the second pixel PX2 and the third pixel PX3 and may surround the light emitting element areas in which the light emitting elements ED are arranged. Accordingly, the extent to which the light emitting elements ED of the second pixel PX2 and the third pixel PX3 are covered may be substantially uniform at all viewing angles looking at the display device 10.

In one or more embodiments, the second light blocking layer BM2 may be arranged in the non-emission area of the second pixels PX2 and the third pixels PX3 so as not to invade (e.g., not to overlap) the first pixels PX1. Accordingly, in an emission mode (e.g., a first emission mode) where the first pixels PX1 are driven, the second light blocking layer BM2 may not substantially block or reduce the light emitted from the first pixels PX1.

In the second pixels PX2 and the third pixels PX3, the size, aperture ratio, and/or opening area of the second light blocking layer BM2 may be different. For example, the second light blocking layer BM2 may be opened wider in the second pixels PX2 and narrower in the third pixels PX3.

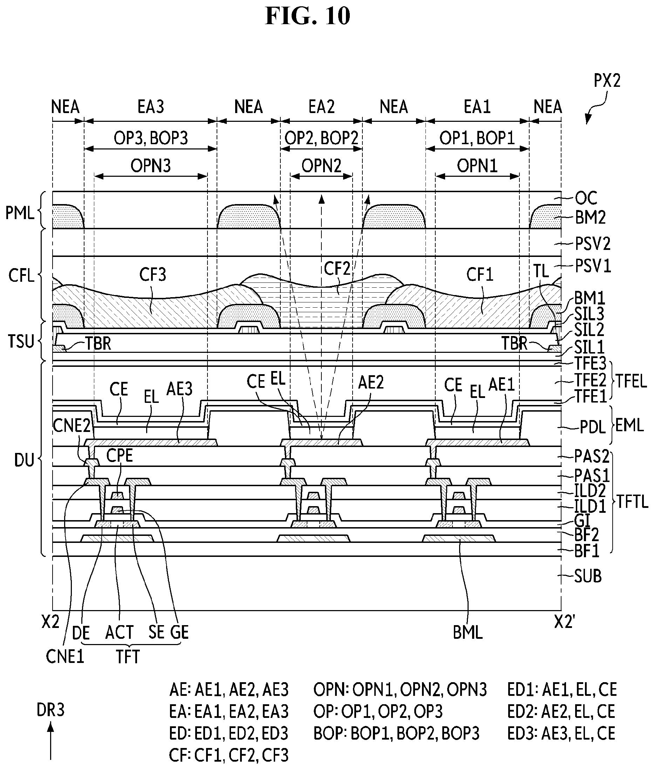

In one or more embodiments, in each second pixel PX2, the second light blocking layer BM2 may include the openings BOP having widths and/or areas greater than the widths and/or areas of the light emitting elements ED of the second pixel PX2. Additionally, in each second pixel PX2, the openings BOP of the second light blocking layer BM2 may surround the openings (e.g., OPN in FIG. 10) of the pixel defining layer at a position spaced apart from the openings of the pixel defining layer in plan view. Accordingly, the second light blocking layer BM2 may surround the light emitting elements ED of the second pixels PX2 at a position spaced apart from the light emitting elements ED of the second pixels PX2 in plan view. For example, the second light blocking layer BM2 may not overlap the light emitting elements ED of the second pixels PX2 in plan view.

In one or more embodiments, in each second pixel PX2, the second light blocking layer BM2 may include the openings BOP having substantially the same size as the openings OP of the first light blocking layer BM1. In one or more embodiments, in each second pixel PX2, the openings OP of the first light blocking layer BM1 and the openings BOP of the second light blocking layer BM2 may have substantially the same size and may substantially completely overlap in plan view. In describing embodiments, "having substantially the same size" may refer to having the same size within an acceptable process tolerance (e.g., accounting for the inherent deviations in measured or calculated values that would be recognized by those of ordinary skill in the art), and "substantially completely overlapping" may refer to being arranged in substantially the same position within an acceptable process tolerance (e.g., accounting for the inherent deviations in measured or calculated values that would be recognized by those of ordinary skill in the art). For example, in each second pixel PX2, the first opening OP1 of the first light blocking layer BM1 and the first opening BOP1 of the second light blocking layer BM2 may have substantially the same size and be arranged at substantially the same position. Similarly, in each second pixel PX2, the second openings OP2 of the first light blocking layer BM1 and the second openings BOP2 of the second light blocking layer BM2 may have substantially the same size and be arranged at substantially the same position, and the third opening OP3 of the first light blocking layer BM1 and the third opening BOP3 of the second light blocking layer BM2 may have substantially the same size and be arranged at substantially the same position.

In one embodiment, one second light blocking layer BM2 of the at least two, in particular four, second light blocking layer BM2 may at least partly overlap the pixel PX and may be provided partly outside the pixel PX, see e. g. fig. 7.

In one or more embodiments, in each third pixel PX3, the second light blocking layer BM2 may include the openings BOP having a size smaller than the openings OP of the first light blocking layer BM1. For example, in each third pixel PX3, the openings BOP of the second light blocking layer BM2 may be arranged inside the openings OP of the first light blocking layer BM1 in plan view. For example, in each third pixel PX3, a width (e.g., a diameter) of the openings BOP of the second light blocking layer BM2 may be smaller than a width (e.g., a diameter) of the openings OP of the first light blocking layer BM1.

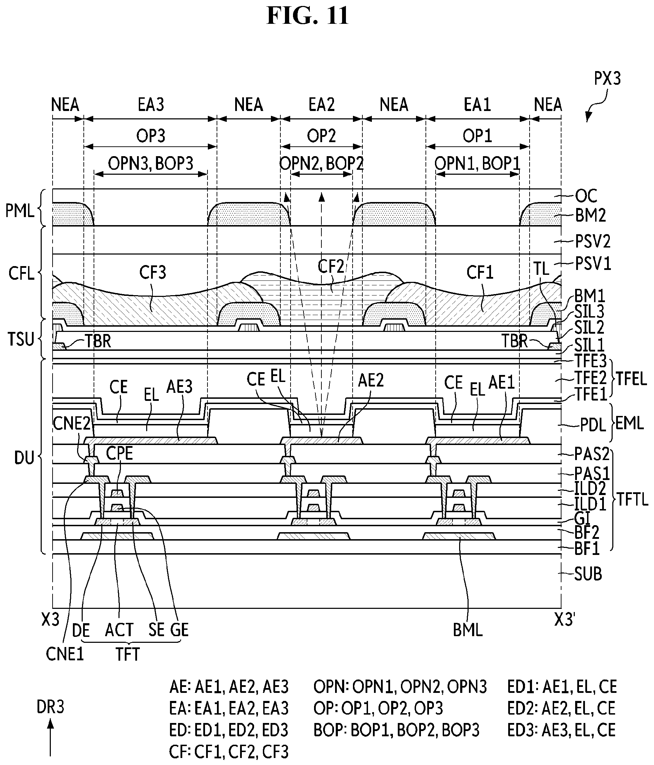

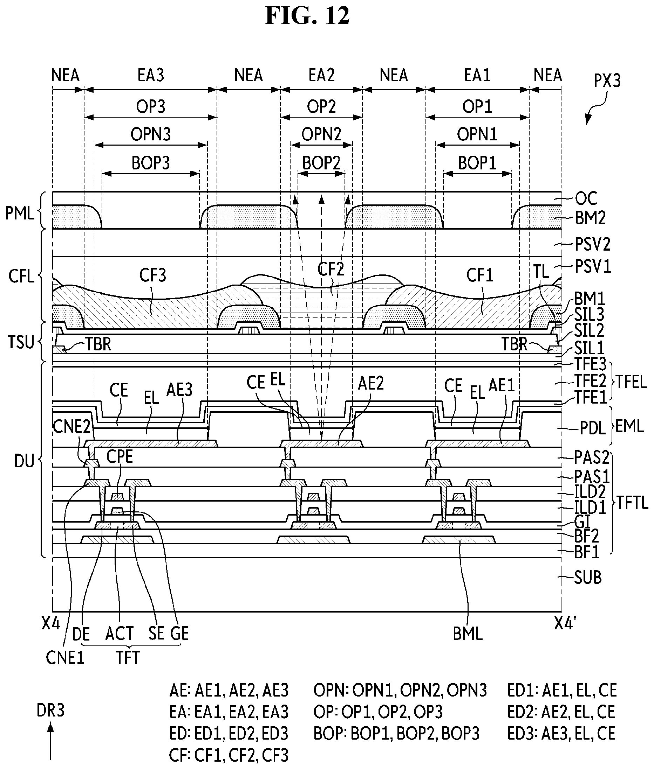

For example, in each third pixel PX3, the second light blocking layer BM2 may include the openings BOP having widths and/or areas that are equal to or smaller than the widths and/or areas of the light emitting elements ED of the third pixel PX3. Further, in each third pixel PX3, the openings BOP of the second light blocking layer BM2 may have substantially the same size and be arranged in substantially the same position as the openings (e.g., OPN in FIG. 11 and/or FIG. 12) of the pixel defining layer in plan view, or may have a smaller size than the openings of the pixel defining layer and be arranged inside the openings of the pixel defining layer. Accordingly, the second light blocking layer BM2 may surround the light emitting elements ED of the third pixels PX3 at a position where it meets the outer perimeters (e.g., outer circumferential surface) of the light emitting elements ED and/or covers (e.g., overlaps) the edge portions of the light emitting elements ED in plan view.

In one or more embodiments, in each third pixel PX3, the second light blocking layer BM2 may include the openings BOP having substantially the same size as the light emitting element areas (e.g., areas in which the pixel defining layer is opened in the third pixel PX3) in which the light emitting elements ED are arranged. For example, as shown in FIG. 7, the second light blocking layer BM2 may include the openings BOP that expose the respective light emitting elements ED in the third pixel PX3, and that meet the edge portions of the light emitting elements ED arranged in the third pixel PX3 in plan view. In one or more embodiments, the second light blocking layer BM2 may, in plan view, include the first opening BOP1 having the same size as the first light emitting element ED1 of the third pixel PX3 and matching the perimeter of the first light emitting element ED1, the second openings BOP2 having the same size as the second light emitting elements ED2 of the third pixel PX3 and matching the perimeter of the second light emitting elements ED2, and the third opening BOP3 having the same size as the third light emitting element ED3 of the third pixel PX3 and matching the perimeter of the third light emitting element ED3. "Matching the perimeter" may refer to an inner circumference of the corresponding opening being aligned or substantially aligned with an outer circumferential surface of the corresponding light emitting element.

In some embodiments, in each third pixel PX3, the second light blocking layer BM2 may include the openings BOP that have a size smaller than the light emitting element areas in which the light emitting elements ED are arranged and that overlap portions of the light emitting elements ED. For example, as shown in FIG. 8, the second light blocking layer BM2 may expose most of the area including the central portions of the respective light emitting elements ED in the third pixel PX3 and may overlap the edge portions of the light emitting elements ED in plan view. In this case, the edge portions of the light emitting elements ED of the third pixel PX3 may be covered by the second light blocking layer BM2. In one or more embodiments, the second light blocking layer BM2 may, in plan view, include the first opening BOP1 that has a size smaller than the first light emitting element ED1 of the third pixel PX3 and overlaps a portion of the first light emitting element ED1, the second openings BOP2 that have a size smaller than the second light emitting elements ED2 of the third pixel PX3 and overlap portions of the second light emitting elements ED2, and the third opening BOP3 that has a size smaller than the third light emitting element ED3 of the third pixel PX3 and overlaps a portion of the third light emitting element ED3.

The side light blocking ratio and/or side luminance ratio of the second pixels PX2 and the third pixels PX3 may vary depending on the distance between the second light blocking layer BM2 and the light emitting elements ED (or the pixel electrodes AE) of the second pixels PX2 and the third pixels PX3, and/or the extent to which the light emitting elements ED of the second pixels PX2 and the third pixels PX3 are covered by the second light blocking layer BM2. For example, as the opening area of the second light blocking layer BM2 decreases, the effective light emitting area and luminance of the pixel PX may decrease and the side light blocking ratio may increase.

In one or more embodiments, the effective light emitting area and/or luminance of the third pixel PX3 may be smaller than the effective emission area and/or luminance of the second pixel PX2, and the side luminance ratio of the third pixel PX3 may be smaller than the side luminance ratio of the second pixel PX2. In one or more embodiments, in a third emission mode where only the third pixels PX3 are driven, the side luminance ratio at an angle of 45° may be 10% or less, e.g., 5% or less. Accordingly, it is possible to effectively or suitably prevent or reduce the possibility of the image being visually recognized from the side and provide a more enhanced (e.g., improved) privacy protection function. In a second emission mode where the second pixels PX2 and the third pixels PX3 are driven, the side luminance ratio and/or viewing angle may increase compared to the third emission mode, but the visibility of the image may be improved due to the increase in front luminance.

FIG. 9 is a cross-sectional view illustrating a display device according to one or more embodiments. For example, FIG. 9 shows a portion of the display device 10 corresponding to the cross-section of the first pixel PX1 taken along the line X1-X1' of FIGS. 4, 5, and 7.

FIG. 10 is a cross-sectional view showing a display device according to one or more embodiments. For example, FIG. 10 shows a portion of the display device 10 corresponding to the cross-section of the second pixel PX2 taken along the line X2-X2' of FIGS. 4, 5, and 7.

FIG. 11 is a cross-sectional view showing a display device according to one or more embodiments. For example, FIG. 11 shows a portion of the display device 10 corresponding to the cross-section of the third pixel PX3 taken along the line X3-X3' of FIGS. 4, 5, and 7.

FIG. 12 is a cross-sectional view illustrating a display device according to one or more embodiments. For example, FIG. 12 shows a portion of the display device 10 corresponding to the cross-section of the third pixels PX3 taken along the line X4-X4' of FIG. 8.

Referring to FIGS. 9 to 12 in addition to FIGS. 1 to 8, the display panel 100 of the display device 10 according to one or more embodiments may include the display layer DU, the touch sensing layer TSU, the color filter layer CFL, and the light blocking member layer PML. The display layer DU may include a substrate SUB, a thin film transistor layer TFTL, a light emitting element layer EML, and an encapsulation layer TFEL. The touch sensing layer TSU may include the touch electrodes TL and bridge patterns TBR. The color filter layer CFL may include the first light blocking layer BM1 and the color filters CF. The light blocking member layer PML may include the second light blocking layer BM2.

The substrate SUB may be a base substrate and/or a base member for forming the display panel 100. In one or more embodiments, the substrate SUB may be a flexible substrate which can be bent, folded and/or rolled, but the present invention is not limited thereto.

The substrate SUB may include the display area DA including the emission areas EA of the pixels PX and a non-emission area NEA around (e.g., surrounding) the emission areas EA. The substrate SUB may further include a peripheral area located around the display area DA. In one or more embodiments, the substrate SUB may further include the non-display area NDA and the sub-region SBA as shown in FIGS. 2 and 3.

The thin film transistor layer TFTL may include a first buffer layer BF1, a lower metal layer BML, a second buffer layer BF2, a thin film transistor TFT, a gate insulating layer GI, a first interlayer insulating layer ILD1, a capacitor electrode CPE, a second interlayer insulating layer ILD2, a first connection electrode CNE1, a first passivation layer PAS1, a second connection electrode CNE2, and a second passivation layer PAS2. However, embodiments are not limited thereto, and the number and/or type (or kind) of conductive layers and insulating layers forming the thin film transistor layer TFTL, and/or the structure and/or type (or kind) of the thin film transistor TFT may be variously suitably changed depending on embodiments.

The first buffer layer BF1 may be arranged on the substrate SUB. The first buffer layer BF1 may include an inorganic film capable of preventing or reducing penetration of air and/or moisture. For example, the first buffer layer BF1 may include a plurality of inorganic films alternately stacked.

The lower metal layer BML may be arranged on the first buffer layer BF1. In one or more embodiments, the lower metal layer BML may be formed as a single layer or multiple layers made of any one selected from among molybdenum (Mo), aluminum (Al), chromium (Cr), gold (Au), titanium (Ti), nickel (Ni), neodymium (Nd) and copper (Cu), or an alloy thereof.

The second buffer layer BF2 may cover the first buffer layer BF1 and the lower metal layer BML. The second buffer layer BF2 may include an inorganic film capable of preventing or reducing penetration of air and/or moisture. For example, the second buffer layer BF2 may include a plurality of inorganic films alternately stacked.

The thin film transistor TFT may be arranged on the second buffer layer BF2, and may be provided to each of the pixel circuits (e.g., pixel circuits of sub-pixels) included in each pixel PX. FIGS. 9 to 12 show the approximate shape of one thin film transistor TFT (e.g., the thin film transistor TFT electrically connected to one first light emitting element ED1, second light emitting element ED2, or third light emitting element ED3) among the thin film transistors TFT that may be provided to the respective pixel circuits (e.g., pixel circuits of sub-pixels) of the first pixel PX1, the second pixel PX2, and the third pixel PX3. Each thin film transistor TFT shown in FIGS. 9 to 12 may be a switching transistor or a driving transistor constituting each pixel circuit. The thin film transistor TFT may include a semiconductor layer ACT, a source electrode SE, a drain electrode DE, and a gate electrode GE.

The semiconductor layer ACT may be arranged on the second buffer layer BF2. The semiconductor layer ACT may overlap the lower metal layer BML and the gate electrode GE in the thickness direction, and may be insulated from the gate electrode GE by the gate insulating layer GI. A part of the semiconductor layer ACT may become conductive (e.g., may become an electron conductor) to form the source electrode SE (or source region) and the drain electrode DE (or drain region).

The gate electrode GE may be arranged on the gate insulating layer GI. The gate electrode GE may overlap the semiconductor layer ACT with the gate insulating layer GI interposed therebetween.

The gate insulating layer GI may be arranged on the semiconductor layer ACT. For example, the gate insulating layer GI may cover the semiconductor layer ACT and the second buffer layer BF2, and may be arranged between the semiconductor layer ACT and the gate electrode GE. The gate insulating layer GI may include a contact hole through which the first connection electrode CNE1 passes.

The first interlayer insulating layer ILD1 may cover the gate electrode GE and the gate insulating layer GI. The first interlayer insulating layer ILD1 may include a contact hole through which the first connection electrode CNE1 passes. The contact hole of the first interlayer insulating layer ILD1 may be connected to the contact hole of the gate insulating layer GI and a contact hole of the second interlayer insulating layer ILD2.

The capacitor electrode CPE may be arranged on the first interlayer insulating layer ILD1. The capacitor electrode CPE may overlap the gate electrode GE in the thickness direction. The capacitor electrode CPE and the gate electrode GE may form a capacitance. For example, a storage capacitor of each pixel circuit may be formed by the capacitor electrode CPE and the gate electrode GE.

The second interlayer insulating layer ILD2 may cover the capacitor electrode CPE and the first interlayer insulating layer ILD1. The second interlayer insulating layer ILD2 may include a contact hole through which the first connection electrode CNE1 passes. The contact hole of the second interlayer insulating layer ILD2 may be connected to the contact hole of the first interlayer insulating layer ILD1 and the contact hole of the gate insulating layer GI.

The first connection electrode CNE1 may be arranged on the second interlayer insulating layer ILD2. The first connection electrode CNE1 may electrically connect the drain electrode DE of the thin film transistor TFT to the second connection electrode CNE2. In one or more embodiments, another connection electrode may also be electrically connected to the source electrode SE of the thin film transistor TFT. When the type or kind of the thin film transistor TFT and/or the structure of the pixel circuit is changed, the first connection electrode CNE1 may electrically connect the source electrode SE of the thin film transistor TFT to the second connection electrode CNE2. The first connection electrode CNE1 may be in contact with and/or connected to the drain electrode DE of the thin film transistor TFT through a contact hole formed in the second interlayer insulating layer ILD2, the first interlayer insulating layer ILD1, and the gate insulating layer GI.

The first passivation layer PAS1 may cover the first connection electrode CNE1 and the second interlayer insulating layer ILD2. The first passivation layer PAS1 may protect the thin film transistor TFT. The first passivation layer PAS1 may include a contact hole through which the second connection electrode CNE2 passes.

The second connection electrode CNE2 may be arranged on the first passivation layer PAS1. The second connection electrode CNE2 may electrically connect the first connection electrode CNE1 to a pixel electrode AE of the light emitting element ED. The second connection electrode CNE2 may be in contact with and/or connected to the first connection electrode CNE1 through a contact hole formed in the first passivation layer PAS1. Further, the second connection electrode CNE2 may be in contact with and/or connected to the pixel electrode AE of the light emitting element ED through a contact hole formed in the second passivation layer PAS2. In some embodiments, the thin film transistor layer TFTL may not include (e.g., may exclude) the second connection electrode CNE2, and the pixel electrode AE of the light emitting element ED may be directly connected to the first connection electrode CNE1 (or one electrode (e.g., the source electrode or the drain electrode) of the thin film transistor TFT).

The second passivation layer PAS2 may cover the second connection electrode CNE2 and the first passivation layer PAS1. The second passivation layer PAS2 may include a contact hole through which the pixel electrode AE of the light emitting element ED passes. In some embodiments, the thin film transistor layer TFTL may not include (e.g., may exclude) the second connection electrode CNE2 and the second passivation layer PAS2, and the pixel electrode AE of the light emitting element ED may be arranged on the first passivation layer PAS1.

The light emitting element layer EML may be arranged on the thin film transistor layer TFTL. The light emitting element layer EML may include the light emitting elements ED and the pixel defining layer PDL.

The light emitting elements ED may be arranged in the respective emission areas EA. In FIGS. 9 to 12, the emission areas EA are defined based on the first light blocking layer BM1. For example, in FIGS. 9 to 12, the emission areas EA may be areas where the light emitting elements ED are exposed through the openings OP of the first light blocking layer BM1. However, the embodiments are not limited thereto, and the light emitting element areas (e.g., areas to which the pixels electrodes AE of the light emitting elements ED are exposed through the openings OPN of the pixel defining layer PDL) defined by the pixel defining layer PDL may be defined as the emission areas EA, and/or the areas where the openings OP of the first light blocking layer BM1 and the openings BOP of the second light blocking layer BM2 overlap may be defined as the emission areas EA.

The light emitting element ED may include the pixel electrode AE (e.g., the first electrode or the anode electrode of the light emitting element ED), the light emitting layer EL, and the common electrode CE (e.g., the second electrode or the cathode electrode of the light emitting element ED). For example, the first light emitting element ED1 arranged in the first emission area EA1 may include the first pixel electrode AE1, and the light emitting layer EL and the common electrode CE that are sequentially arranged on the first pixel electrode AE1. The second light emitting element ED2 arranged in the second emission area EA2 may include the second pixel electrode AE2, and the light emitting layer EL and the common electrode CE that are sequentially arranged on the second pixel electrode AE2. The third light emitting element ED3 arranged in the third emission area EA3 may include the third pixel electrode AE3, and the light emitting layer EL and the common electrode CE that are sequentially arranged on the third pixel electrode AE3.

The pixel electrode AE may be arranged on the second passivation layer PAS2. Different pixel electrodes AE may be arranged in the respective emission areas EA corresponding to different openings OPN among the openings OPN of the pixel defining layer PDL. For example, the first pixel electrode AE1, the second pixel electrode AE2, and the third pixel electrode AE3 of the first pixel PX1 may be arranged in the first emission area EA1, the second emission area EA2, and the third emission area EA3 of the first pixel PX1, respectively. The first pixel electrode AE1, the second pixel electrode AE2, and the third pixel electrode AE3 of the second pixel PX2 may be arranged in the first emission area EA1, the second emission area EA2, and the third emission area EA3 of the second pixel PX2, respectively. The first pixel electrode AE1, the second pixel electrode AE2, and the third pixel electrode AE3 of the third pixel PX3 may be arranged in the first emission area EA1, the second emission area EA2, and the third emission area EA3 of the third pixel PX3, respectively.

In one or more embodiments, at least a part of each of the pixel electrodes AE may be exposed without being covered by the pixel defining layer PDL. For example, most of the area of each first pixel electrode AE1 that includes the central portion thereof may be exposed by a first opening OPN1 of the pixel defining layer PDL, most of the area of each second pixel electrode AE2 that includes the central portion thereof may be exposed by a second opening OPN2 of the pixel defining layer PDL, and most of the area of each third pixel electrode AE3 that includes the central portion thereof may be exposed by a third opening OPN3 of the pixel defining layer PDL. The edge portions of the pixel electrodes AE may be covered by the pixel defining layer PDL.

The respective light emitting layers EL may be arranged on a part of the corresponding pixel electrodes AE exposed by the openings OPN of the pixel defining layer PDL. Accordingly, the respective light emitting elements ED may be arranged and/or formed in the respective emission areas EA. For example, the light emitting elements ED may be arranged in the openings OPN of the pixel defining layer PDL. The areas where the respective light emitting elements ED are formed by the openings OPN of the pixel defining layer PDL may also be referred to as the light emitting element areas. The light emitting element areas may correspond to the respective emission areas EA. For example, each light emitting element area may be (e.g., may constitute) all or a portion of the emission area EA in which the corresponding light emitting element ED is arranged.

The pixel electrode AE may be electrically connected to one electrode of the thin film transistor TFT. For example, the pixel electrode AE may be electrically connected to the drain electrode DE of the thin film transistor TFT through the first connection electrode CNE1 and the second connection electrode CNE2.

The light emitting layer EL may be arranged on the pixel electrode AE. In one or more embodiments, the light emitting layer EL may be an organic light emitting layer made of an organic material, but the present invention is not limited thereto.

In one or more embodiments, the light emitting layers EL of the first light emitting element ED1, the second light emitting element ED2, and the third light emitting element ED3 may be to emit lights of different colors. For example, the light emitting layer EL of the first light emitting element ED1 may be to emit light of the first color, e.g., red light, the light emitting layer EL of the second light emitting element ED2 may be to emit light of the second color, e.g., green light, and the light emitting layer EL of the third light emitting element ED3 may be to emit light of the third color, e.g., blue light.

However, the embodiments are not limited thereto. For example, in some embodiments, the light emitting layer EL of the light emitting elements ED may be formed as one common layer entirely arranged on the different pixel electrodes AE and the pixel defining layer PDL, and the light emitting layer EL arranged on different pixel electrodes AE may be to emit light of the same color. In this case, the display device 10 may further include a color adjustment layer (e.g., color conversion layer including wavelength conversion patterns and/or color adjustment layer including the color filters CF) arranged on the light emitting elements ED.

The common electrode CE may be arranged on the light emitting layer EL of each of the light emitting elements ED. In one or more embodiments, the common electrode CE may be formed as one common layer arranged entirely in the display area DA, and the light emitting elements ED of the pixels PX may share one common electrode CE. The common electrode CE may receive a common voltage (e.g., second pixel voltage or cathode voltage).

The pixel defining layer PDL may include the openings OPN corresponding to the emission areas EA and may be arranged on a part of the pixel electrodes AE and the second passivation layer PAS2. For example, the pixel defining layer PDL may be arranged at least in the non-emission area NEA, and may include the first opening OPN1 arranged in each first emission area EA1, the second opening OPN2 arranged in each second emission area EA2, and the third opening OPN3 arranged in each third emission area EA3.

In one or more embodiments, the openings OPN of the pixel defining layer PDL may have a size smaller than that of each of the emission areas EA, and may be arranged in the emission areas EA. However, the embodiments are not limited thereto. For example, the openings OPN of the pixel defining layer PDL may have substantially the same size as that of each of the emission areas EA. The pixel defining layer PDL may overlap the first light blocking layer BM1 and the second light blocking layer BM2 (e.g., along the third direction DR3).

In one or more embodiments, the openings OPN of the pixel defining layer PDL may have different sizes. For example, the openings OPN of the pixel defining layer PDL may have sizes corresponding to those of the respective emission areas EA. For example, the size (or a first aperture ratio corresponding to the first emission area EA1) of each first opening OPN1 may be larger than the size (or a second aperture ratio corresponding to the second emission area EA2) of each second opening OPN2, and may be smaller than the size (or a third aperture ratio corresponding to the third emission area EA3) of each third opening OPN3.

In one or more embodiments, the pixel defining layer PDL may be opened with (e.g., may have openings of) substantially the same area in a first pixel area where each first pixel PX1 is arranged, a second pixel area where each second pixel PX2 is arranged, and a third pixel area where each third pixel PX3 is arranged. For example, the size of the first opening OPN1 arranged in the first emission area EA1 of the first pixel PX1, the size of the first opening OPN1 arranged in the first emission area EA1 of the second pixel PX2, and the size of the first opening OPN1 arranged in the first emission area EA1 of the third pixel PX3 may be substantially the same or similar. The size of the second opening OPN2 arranged in the second emission area EA2 of the first pixel PX1, the size of the second opening OPN2 arranged in the second emission area EA2 of the second pixel PX2, and the size of the second opening OPN2 arranged in the second emission area EA2 of the third pixel PX3 may be substantially the same or similar, and the size of the third opening OPN3 arranged in the third emission area EA3 of the first pixel PX1, the size of the third opening OPN3 arranged in the third emission area EA3 of the second pixel PX2, and the size of the third opening OPN3 arranged in the third emission area EA3 of the third pixel PX3 may be substantially the same or similar.

In one or more embodiments, the pixel defining layer PDL may include a light absorbing material to prevent or reduce light reflection. For example, the pixel defining layer PDL may include a polyimide (PI)-based binder and a pigment in which red, green, and blue colors are mixed. In one or more embodiments, the pixel defining layer PDL may include a cardo-based binder resin and a mixture of a lactam black pigment and a blue pigment. In one or more embodiments, the pixel defining layer PDL may include carbon black.

The encapsulation layer TFEL may be arranged on the common electrode CE to cover the light emitting elements ED. The encapsulation layer TFEL may include at least one inorganic film to prevent or reduce penetration of oxygen and/or moisture into the light emitting element layer EML. The encapsulation layer TFEL may include at least one organic film to protect the light emitting element layer EML from foreign matters such as dust.

In one or more embodiments, the encapsulation layer TFEL may include a first encapsulation layer TFE1, a second encapsulation layer TFE2, and a third encapsulation layer TFE3 that are sequentially arranged on the light emitting elements ED. The first encapsulation layer TFE1 and the third encapsulation layer TFE3 may be inorganic films, and the second encapsulation layer TFE2 may be an organic film.

Each of the first encapsulation layer TFE1 and the third encapsulation layer TFE3 may include an inorganic insulating material. For example, each of the first encapsulation layer TFE1 and the third encapsulation layer TFE3 may include aluminum oxide, titanium oxide, tantalum oxide, hafnium oxide, zinc oxide, silicon oxide, silicon nitride, silicon oxynitride and/or another suitable inorganic insulating material.

The second encapsulation layer TFE2 may include an organic insulating material. For example, the second encapsulation layer TFE2 may include a polymerbased organic insulating material such as acrylic resin, epoxy resin, polyimide, and/or polyethylene, and/or may include another suitable organic insulating material. The second encapsulation layer TFE2 may be formed by curing a monomer or applying a polymer.

The touch sensing layer TSU may be arranged on the encapsulation layer TFEL. For example, the touch sensing layer TSU may be arranged between the display layer DU and the color filter layer CFL. However, embodiments are not limited thereto, and the location of the touch sensing layer TSU may suitably vary depending on embodiments. In some embodiments, the touch sensing layer TSU and the display layer DU may be integrated, or the display device 10 may not include (e.g., may exclude) a separate touch sensing layer TSU. In this case, the color filter layer CFL may be arranged directly on the display layer DU.

The touch sensing layer TSU may include a first insulating layer SIL1, a second insulating layer SIL2, the touch electrode TL, and a third insulating layer SIL3. In one or more embodiments, one selected from among the first insulating layer SIL1 and the third insulating layer SIL3 may not be provided.

The touch sensing layer TSU may include conductive patterns including the touch electrodes TL. The conductive patterns may be sensing patterns used for sensing a touch input. For example, the conductive patterns of the touch sensing layer TSU may be utilized to sense a change in electrical characteristics (e.g., an amount of change in capacitance) according to a touch input, and to detect the touch input.

In one or more embodiments, the touch electrodes TL may be formed as mesh patterns including openings exposing the emission areas EA of the pixels PX in plan view. For example, each touch electrode TL and/or each of a plurality of electrode cells constituting the touch electrode TL may be a mesh pattern formed of thin lines overlapping the light blocking layer BM and arranged in the non-emission area. For example, in FIG. 10, the touch electrodes TL arranged between the emission areas EA of the second pixel PX2 may be different parts of the mesh pattern forming one touch electrode TL. The touch sensing layer TSU may include the plurality of touch electrodes TL arranged at positions corresponding to touch nodes of the display area DA, and the size, resolution, and/or arrangement interval of the touch electrodes TL may be the same as or different from the size, resolution, and/or arrangement interval of the pixels PX.

In one or more embodiments, the conductive patterns of the touch sensing layer TSU may further include the bridge patterns TBR for connecting the touch electrodes TL (or electrode cells forming the touch electrodes TL) in a desired or suitable shape and/or structure. Each bridge pattern TBR may overlap a part (e.g., two electrode cells included in the touch electrode TL and adjacent to each other) of at least one touch electrode TL, and may be electrically connected to the touch electrode TL.

In one or more embodiments, the conductive patterns of the touch sensing layer TSU may be arranged in the non-emission area NEA around the emission areas EA, and may be covered with the light blocking layer BM. Accordingly, visual recognition of the conductive patterns of the touch sensing layer TSU by the user may be prevented or reduced.

In one or more embodiments, the touch sensing layer TSU may include a plurality of conductive layers. For example, the touch sensing layer TSU may include a first conductive layer (e.g., a lower conductive layer) including the bridge patterns TBR and a second conductive layer (e.g., an upper conductive layer) including the touch electrodes TL. The second insulating layer SIL2 may be arranged between the first conductive layer and the second conductive layer. In one or more embodiments, the first conductive layer may be arranged under the second insulating layer SIL2, and the second conductive layer may be arranged above the second insulating layer SIL2, but the present invention is not limited thereto. For example, the arrangement order and/or position of the first conductive layer and the second conductive layer may be suitably changed.

The first insulating layer SIL1 may be arranged on the encapsulation layer TFEL. The first insulating layer SIL1 may have an insulating function and an optical function. In one or more embodiments, the first insulating layer SIL1 may include at least one inorganic film. In some embodiments, the first insulating layer SIL1 may not be provided.

The bridge pattern TBR may be arranged on the first insulating layer SIL1. The bridge pattern TBR may include a conductive material and may be formed as a single layer or multiple layers.

The second insulating layer SIL2 may be arranged on the bridge pattern TBR. For example, the second insulating layer SIL2 may cover the bridge pattern TBR and the first insulating layer SIL1, and may be arranged between the touch electrode TL and the bridge pattern TBR. The second insulating layer SIL2 may include a contact hole through which the touch electrode TL (or the bridge pattern TBR) passes at a portion where the touch electrode TL and the bridge pattern TBR are connected.

The second insulating layer SIL2 may have an insulating function and an optical function. In one or more embodiments, the second insulating layer SIL2 may be an inorganic film containing at least one selected from among a silicon nitride layer, a silicon oxynitride layer, a silicon oxide layer, a titanium oxide layer, and an aluminum oxide layer. In some embodiments, the second insulating layer SIL2 may be an optically transparent organic film.

The touch electrode TL (or a part of the touch electrodes TL in the display area DA) may be arranged on the second insulating layer SIL2. The touch electrode TL may include a conductive material and may be formed as a single layer or multiple layers.

In one or more embodiments, the touch electrode TL may not overlap the pixel electrodes AE. For example, the touch electrode TL may be arranged in the non-emission area NEA, and may overlap the pixel defining layer PDL and the light blocking layer BM.

In one or more embodiments, the light blocking layer BM may have a width enough to completely cover the touch electrode TL. In one or more embodiments, the touch electrode TL may be arranged such that the center thereof is almost parallel to (e.g., is substantially aligned with) the center of the light blocking layer BM, and the gap from both sides (e.g., opposite ends of the top surface) of the touch electrode TL to the edge (e.g., inner edge) of the light blocking layer BM may be substantially uniform.

The third insulating layer SIL3 may be arranged on the touch electrode TL. For example, the third insulating layer SIL3 may cover the touch electrode TL and the second insulating layer SIL2. The third insulating layer SIL3 may have an insulating function and an optical function. In one or more embodiments, the third insulating layer SIL3 may include a material exemplified as the material of the second insulating layer SIL2. In some embodiments, the third insulating layer SIL3 may not be provided.

The color filter layer CFL may be arranged on the touch sensing layer TSU (or display layer DU). The color filter layer CFL may include the first light blocking layer BM1, the color filters CF, and at least one passivation layer. For example, the color filter layer CFL may include the first light blocking layer BM1, the color filters CF, the first passivation layer PSV1, and the second passivation layer PSV2.

The first light blocking layer BM1 may be arranged on the touch sensing layer TSU. The first light blocking layer BM1 may include a light blocking material (e.g., a light absorbing material or light reducing material) such as a black matrix material.

The first light blocking layer BM1 may be arranged in the non-emission area NEA, and may include the openings OP that expose the light emitting elements ED. For example, the first light blocking layer BM1 may include the first opening OP1 arranged in the first emission area EA1 to expose the first light emitting element ED1, the second opening OP2 arranged in the second emission area EA2 to expose the second light emitting element ED2, and the third opening OP3 arranged in the third emission area EA3 to expose the third light emitting element ED3. In one or more embodiments, when the first light blocking layer BM1 is more narrowly opened in the second pixel PX2 and the third pixel PX3 compared to the first pixel PX1, the substantial size (e.g., the light emitting area, namely, the area from which light may be emitted) of the emission areas EA in each of the second pixel PX2 and the third pixel PX3 may be smaller than the substantial size of the emission areas EA in the first pixel PX1.

The color filters CF may be arranged on the touch sensing layer TSU and the first light blocking layer BM1. The color filters CF may be arranged in the respective emission areas EA and overlap the respective light emitting elements ED. In one or more embodiments, the color filters CF may also be arranged around the respective emission areas EA, and at least two color filters CF adjacent between the emission areas EA may overlap each other. For example, the color filters CF may cover the light emitting elements ED arranged in the respective emission areas EA, and may extend into the non-emission area NEA around the emission areas EA to overlap the first light blocking layer BM1.

The color filters CF may include first color filters CF1 arranged in the first emission areas EA1, second color filters CF2 arranged in the second emission areas EA2, and third color filters CF3 arranged in the third emission areas EA3. The color filters CF may contain a colorant such as a dye and/or a pigment that absorbs light of a wavelength band other than a set or specific wavelength band.

The first color filters CF1 may be to transmit the light of the first color emitted from the first light emitting elements ED1 arranged in the first emission areas EA1, and may be to absorb and/or block or reduce light of another color (e.g., light of the second color and light of the third color). For example, each first color filter CF1 may be a red color filter that selectively transmits only (or predominantly) red light emitted from each first light emitting element ED1.

The second color filters CF2 may be to transmit the light of the second color emitted from the second light emitting elements ED2 of the second emission areas EA2, and may be to absorb and/or block or reduce light of another color (e.g., the light of the first color and the light of the third color). For example, each second color filter CF2 may be a green color filter that selectively transmits only (or predominantly) green light emitted from each second light emitting element ED2.

The third color filters CF3 may be to transmit the light of the third color emitted from the third light emitting elements ED3 of the third emission areas EA3, and may be to absorb and/or block or reduce light of another color (e.g., the light of the first color and the light of the second color). For example, each third color filter CF3 may be a blue color filter that selectively transmits only (or predominantly) blue light emitted from each third light emitting element ED3.

Although FIGS. 9 to 12 illustrate embodiments in which the color filters CF are formed in individual patterns corresponding to the respective emission areas EA, the embodiments are not limited thereto. For example, in some embodiments, the color filters CF may be formed across the entire display area DA. For example, the first color filter CF1 may include openings formed entirely in the display area DA and corresponding to the second emission areas EA2 and the third emission areas EA3, the second color filter CF2 may include openings formed entirely in the display area DA and corresponding to the first emission areas EA1 and the third emission areas EA3, and the third color filter CF3 may include openings formed entirely in the display area DA and corresponding to the first emission areas EA1 and the second emission areas EA2.

Additionally, although FIGS. 9 to 12 illustrate embodiments in which the first light blocking layer BM1 is formed as a light blocking pattern separate from the color filters CF, the embodiments are not limited thereto. For example, in some embodiments, the first light blocking layer BM1 may be formed as part of the color filters CF rather than being formed as a separate first light blocking layer BM1. In one or more embodiments, the first light blocking layer BM1 may be formed by overlapping the first color filter CF1, the second color filter CF2, and the third color filter CF3 in the non-emission area NEA.

Because the color filters CF and the first light blocking layer BM1 are arranged on the display layer DU, the intensity of reflected light due to external light may be reduced.

The first passivation layer PSV1 and the second passivation layer PSV2 may be sequentially arranged on the first light blocking layer BM1 and the color filters CFL. The first passivation layer PSV1 and the second passivation layer PSV2 may be entirely arranged in the display area DA, thereby flattening (or substantially flattening) the stepped portion caused by the color filters CF and the first light blocking layer BM1.

The first passivation layer PSV1 and the second passivation layer PSV2 may be light transmissive layers. For example, the first passivation layer PSV1 and the second passivation layer PSV2 may include a colorless light transmissive organic material such as an acrylic resin.

The light blocking member layer PML may be arranged on the color filter layer CFL. The light blocking member layer PML may include the second light blocking layer BM2 and an overcoat layer OC.

The second light blocking layer BM2 may be arranged on the color filter layer CFL. The second light blocking layer BM2 may include a light blocking material (e.g., a light absorbing material) such as a black matrix material. The material of the first light blocking layer BM1 and the material of the second light blocking layer BM2 may be the same or different.

The second light blocking layer BM2 may not be arranged in the first pixels PX1, and may be arranged only in the second pixels PX2 and the third pixels PX3. The second light blocking layer BM2 may surround the light emitting elements ED of the second pixels PX2 and the third pixels PX3 in plan view. For example, the second light blocking layer BM2 may be arranged in the non-emission area NEA of the second pixels PX2 and the third pixels PX3 and may entirely or partially surround the emission areas EA of the second pixels PX2 and the third pixels PX3.

In each second pixel PX2, the second light blocking layer BM2 may include the openings BOP having widths and/or sizes larger than the widths and/or sizes of the openings OPN of the pixel defining layer PDL. For example, in the second pixel PX2, the second light blocking layer BM2 may include the first opening BOP1, the second opening BOP2, and the third opening BOP3 that have widths larger than the widths of the first opening OPN1, the second opening OPN2, and the third opening OPN3 of the pixel defining layer PDL, respectively, and expose the first light emitting element ED1, the second light emitting element ED2, and the third light emitting element ED3, respectively.

In each third pixel PX3, the second light blocking layer BM2 may include the openings BOP having widths and/or sizes equal to or smaller than the widths and/or sizes of the openings OPN of the pixel defining layer PDL. For example, as illustrated in FIG. 11, the second light blocking layer BM2 in the third pixel PX3 may include the first opening BOP1, the second opening BOP2, and the third opening BOP3 that have widths substantially the same as the widths of the first opening OPN1, the second opening OPN2, and the third opening OPN3 of the pixel defining layer PDL, respectively, and expose the first light emitting element ED1, the second light emitting element ED2, and the third light emitting element ED3, respectively. For example, in plan view, the openings BOP of the second light blocking layer BM2 arranged in each third pixel PX3 may have substantially the same size as the openings OPN of the pixel defining layer PDL arranged in each third pixel PX3 and may completely overlap the openings OPN of the pixel defining layer PDL. In one or more embodiments, the second light blocking layer BM2 arranged in each third pixel PX3 may be in contact with the perimeter (e.g., outer circumferential surface) of the light emitting elements ED arranged in each third pixel PX3 in plan view.

In one or more embodiments, as shown in FIG. 12, the second light blocking layer BM2 in the third pixel PX3 may include the first opening BOP1, the second opening BOP2, and the third opening BOP3 that have widths smaller than the widths of the first opening OPN1, the second opening OPN2, and the third opening OPN3 of the pixel defining layer PDL, respectively, and may expose most of the area including the central portions of the first light emitting element ED1, the second light emitting element ED2, and the third light emitting element ED3, respectively. For example, in plan view, the openings BOP of the second light blocking layer BM2 arranged in each third pixel PX3 may have smaller sizes than the openings OPN of the pixel defining layer PDL arranged in each third pixel PX3, and may be arranged inside the openings OPN of the pixel defining layer PDL. In one or more embodiments, the second light blocking layer BM2 arranged in each third pixel PX3 may cover the edge portions of the light emitting elements ED arranged in each third pixel PX3 in plan view.

The size, shape, and/or position of the second light blocking layer BM2 may be adjusted and/or changed according to a target luminance, a viewing angle range, and/or the like desired or required in each of the second pixel PX2 and the third pixel PX3. When the second light blocking layer BM2 is opened more narrowly in the third pixel PX3 than in the second pixel PX2, the effective light emitting area and/or viewing angle of the third pixel PX3 may be smaller than the effective light emitting area and/or viewing angle of the second pixel PX2.

The overcoat layer OC may be arranged on the second light blocking layer BM2. The overcoat layer OC may cover the color filter layer CFL and the second light blocking layer BM2.

As described above, the display device 10 according to one or more embodiments includes the first pixels PX1, the second pixels PX2, and the third pixels PX3 having different side light emission ratios and/or viewing angles. In one or more embodiments, the side light emission ratios and/or viewing angles of the first pixels PX1, the second pixels PX2, and the third pixels PX3 may be differentiated by using at least one selected from among the first light blocking layer BM1 and the second light blocking layer BM2. For example, by selectively and/or differentially arranging the second light blocking layer BM2 in the first pixels PX1, the second pixels PX2, and the third pixels PX3, the light exit angles and the side luminance ratios of the first pixels PX1, the second pixels PX2, and the third pixels PX3 may be differentiated. In one or more embodiments, in FIGS. 9 to 11, as indicated by the dotted arrows, the light exit angle of light emitted from the second light emitting element ED2 of each of the first pixel PX1, the second pixel PX2, and the third pixel PX3 may vary depending on the first light blocking layer BM1 and the second light blocking layer BM2. For example, the light exit angle of light emitted from the second light emitting element ED2 of the second pixel PX2 may be smaller than the light exit angle of light emitted from the second light emitting element ED2 of the first pixel PX1, and larger than the light exit angle of light emitted from the second light emitting element ED2 of each third pixel PX3. Additionally, as indicated by the dotted arrows in FIG. 12, the light exit angle of light emitted from the second light emitting element ED2 may further decrease as the width of the second opening BOP of the second light blocking layer BM2 decreases.

In the display device 10 according to one or more embodiments, the side visibility may be adjusted according to each emission mode. For example, by selectively driving the first pixels PX1, the second pixels PX2, and the third pixels PX3, the luminance and viewing angle of the image displayed in the display area DA may be appropriately or suitably controlled or selected or varied according to each emission mode.

In one or more embodiments, the first pixels PX1 may be driven only in a first emission mode, and may be turned off or may not emit light in the second emission mode and the third emission mode. The second pixels PX2 may be driven in the first emission mode and the second emission mode, and may be turned off or not emit light in the third emission mode. The third pixels PX3 may be driven in all of the first emission mode, the second emission mode, and the third emission mode.

The first emission mode may be a general mode, e.g., a wide viewing angle mode, where the viewing angle of the image displayed in the display area DA is not limited, and the second and third emission modes may be viewing angle limiting modes, e.g., a privacy protection mode and/or a security mode, where the viewing angle of the image displayed in the display area DA is limited.

In the first emission mode, the first pixels PX1 having a relatively large light exit angle may be driven. In one or more embodiments, in response to the first emission mode, the second pixels PX2 and/or the third pixels PX3 may be further driven along with the first pixels PX1. For example, in the first emission mode, all pixels PX in the display area DA including the first pixels PX1, the second pixels PX2, and the third pixels PX3 may be driven. Accordingly, in the first emission mode, the luminance (e.g., front luminance and side luminance) of the display device 10 may be improved or ensured, and a relatively wide viewing angle may be provided. For example, while the display device 10 is driven in the first emission mode, the side luminance ratio at a viewing angle of 45° may be 20% or more. Accordingly, the image may be visually recognized even when the display device 10 is viewed from the side.

If it is desired or suitable to limit the side visibility of the display device 10, the display device 10 may be driven in the second emission mode or the third emission mode. In the second emission mode and the third emission mode, among the pixels PX in the display area DA, only some pixels PX having a relatively small light exit angle may be driven. In one or more embodiments, in the second emission mode and the third emission mode, the second pixels PX2 and the third pixels PX3 may be selectively driven while the first pixels PX1 are turned off (e.g., in a non-emission state). Accordingly, the viewing angle of the display device 10 may be limited. For example, while the display device 10 is driven in the second emission mode and the third emission mode, when the display device 10 is viewed from the side, most of the side light emitted from the second pixels PX2 and/or the third pixels PX3 may be blocked or substantially reduced by the second light blocking layer BM2. For example, while the display device 10 is driven in the second emission mode, the side luminance ratio at a viewing angle of 45° may be reduced to 20% or less (e.g., 10% or less). Accordingly, while the display device 10 is driven in the second emission mode and the third emission mode, the image may be visually recognized only by the user looking at the display device 10 from the front, and the image may not be properly visually recognized by the user looking at the display device 10 from a specific viewing angle and/or from the side. Accordingly, it is possible to appropriately or suitably limit the viewing angle of the display device 10 in response to the second emission mode and the third emission mode, and provide a privacy protection function, a security function, and/or the like in accordance with the operational purpose of the second emission mode and the third emission mode.

Even in the second emission mode and the third emission mode, the luminance and/or viewing angle of the display device 10 may be further adjusted and/or changed by selectively driving the second pixels PX2 and the third pixels PX3. For example, by driving the second pixels PX2 and the third pixels PX3 together in response to the second emission mode, the side visibility of the display device 10 may be limited compared to the first emission mode, while improving the luminance (e.g., front luminance) of the display device 10 compared to the third emission mode. In contrast, by driving only the third pixels PX3 having the narrowest light exit angle in response to the third emission mode, the side light of the display device 10 may be more effectively blocked, and the side visibility of the display device 10 may be more effectively blocked. For example, while the display device 10 is driven in the third emission mode, the side luminance ratio at a viewing angle of 45° may be reduced to 10% or less (e.g., 5% or less). Accordingly, in the third emission mode, a more enhanced privacy protection function, security function, and/or the like may be provided.

However, the number and/or type (or kind) of the emission modes utilizing the first pixels PX1, the second pixels PX2, and the third pixels PX3 is not limited thereto. For example, the number and/or type (or kind) of the emission modes that can be selected to adjust the luminance and/or viewing angle of the image, and/or the number and/or type (or kind) of the pixels PX driven in each emission mode may be variously suitably changed according to one or more embodiments. For example, the luminance and/or viewing angle of the image may be adjusted in the plurality of emission modes based on one or more suitable possible combinations of the selective driving of the first pixels PX1, the second pixels PX2, and the third pixels PX3.

As described above, the display device 10 according to one or more embodiments includes the first pixels PX1, the second pixels PX2, and the third pixels PX3 having different side light emission ratios. In one or more embodiments, by selectively and/or differentially arranging the second light blocking layer BM2 in the first pixels PX1, the second pixels PX2, and the third pixels PX3, the side light blocking ratios of the first pixels PX1, the second pixels PX2, and the third pixels PX3 may be differentiated. For example, by arranging the second light blocking layer BM2 with a different aperture ratio and/or opening area in the second pixels PX2 and the third pixels PX3 without placing the second light blocking layer BM2 in the first pixels PX1, the side light blocking ratios of the first pixels PX1, the second pixels PX2, and the third pixels PX3 may be differentiated.

According to one or more embodiments, by selectively driving the first pixels PX1, the second pixels PX2, and the third pixels PX3 according to each emission mode, the luminance (e.g., front luminance and side luminance) and viewing angle of the display device 10 may be appropriately or suitably changed, improved and/or optimized. For example, in the first emission mode, which does not limit the viewing angle, all pixels PX in the display area DA including the first pixels PX1, the second pixels PX2, and the third pixels PX3 may be driven to improve or ensure the luminance of the display device 10 and provide a wide viewing angle. Additionally, in the second and third emission modes, which limit the viewing angle, the first pixels PX1 with a high side light emission ratio may be turned off and the second pixels PX2 and/or the third pixels PX3 with a relatively low side light emission ratio may be driven to effectively or suitably limit the side luminance and/or viewing angle of the display device 10. Additionally, according to one or more embodiments, even in the second and third emission modes, which limit the viewing angle, the luminance and viewing angle of the display device 10 may be further adjusted in each emission mode by selectively driving the second pixels PX2 and third pixels PX3. Accordingly, more diverse emission modes may be provided to a user and the convenience of use of the display device 10 may be increased.

In concluding the detailed description, those skilled in the art will appreciate that many variations and modifications can be made to the embodiments without substantially departing from the principles of the present invention as defined by the appended claims. Therefore, the disclosed embodiments of the invention are used in a generic and descriptive sense only and not for purposes of limitation.

## Claims

1. A display device (10) comprising:
a substrate (SUB) comprising a display area (DA) comprising emission areas (EA) of a first pixel (PX1), a second pixel (PX2), and a third pixel (PX3), and a non-emission area (NEA) surrounding the emission areas (EA);
a light emitting element layer (EML) on the substrate (SUB), and comprising light emitting elements (ED) in the emission areas (EA);
a color filter layer (CFD) on the light emitting element layer (EML), and comprising color filters (CF) in the emission areas (EA) and a first light blocking layer (BM1) in the non-emission area (NEA); and
a second light blocking layer (BM2) on the color filter layer (CFD), and in the non-emission area (NEA) of the second pixel (PX2) and the third pixel (PX3) while surrounding the emission areas (EA) of the second pixel (PX2) and the third pixel (PX3),
wherein the second light blocking layer (BM2) comprises openings (OP) having a width larger than a width of the light emitting elements (ED) of the second pixel (PX2) in the second pixel (PX2), and comprises openings (OP) having a width smaller than or equal to a width of the light emitting elements (ED) of the third pixel (PX3) in the third pixel (PX3).

2. The display device (10) of claim 1, wherein the light emitting element layer (EML) further comprises a pixel defining layer (PDL) in the non-emission area (NEA) and comprising openings (OPN) corresponding to the emission areas (EA), and
the light emitting elements (ED) are in the openings (OPN) of the pixel defining layer (PDL).

3. The display device (10) of claim 2, wherein in the second pixel (PX2), the width of the openings (OP) of the second light blocking layer (BM2) is larger than a width of the openings (OPN) of the pixel defining layer (PDL).

4. The display device (10) of claim 2 or 3, wherein in the second pixel (PX2), the openings (OP) of the second light blocking layer (BM2) surround the openings (OPN) of the pixel defining layer (PDL) and are spaced apart from the openings (OPN) of the pixel defining layer (PDL) in plan view.

5. The display device (10) of at least one of claims 1 to 4, wherein the second light blocking layer (BM2) does not overlap the light emitting elements (ED) in the second pixel (PX2) in plan view.

6. The display device (10) of claim 1 or 2, wherein in the third pixel (PX3), the width of the openings (OP) of the second light blocking layer (BM2) is smaller than or equal to a width of the openings (OPN) of the pixel defining layer (PDL).

7. The display device (10) of claim 6, wherein in the third pixel (PX3), the openings (OP) of the second light blocking layer (BM2) have the same width as the openings (OPN) of the pixel defining layer (PDL) and completely overlap the openings (OPN) of the pixel defining layer (PDL).

8. The display device (10) of at least one of claims 1 to 7, wherein in plan view, the second light blocking layer (BM2) is in contact with a perimeter of the light emitting elements (ED) in the third pixel (PX3).

9. The display device (10) of claim 1, 2 or 6, wherein in the third pixel (PX3), the openings (OP) of the second light blocking layer (BM2) have a smaller width than the width of the openings (OPN) of the pixel defining layer (PDL) and are inside the openings (OPN) of the pixel defining layer (PDL).

10. The display device (10) of at least one of claims 1 to 9, wherein a portion of the second light blocking layer (BM2) covers an edge portion of the light emitting elements (ED) in the third pixel (PX3).

11. The display device (10) of at least one of claims 1 to 10, wherein the first light blocking layer (BM1) comprises openings (OP) corresponding to and exposing the emission areas (EA).

12. The display device (10) of claim 11, wherein a size of the openings (OP) of the first light blocking layer (BM1) exposing the emission areas (EA) of the first pixel (PX1) is larger than a size of the openings (OP) of the second light blocking layer (BM2) exposing the emission areas (EA) of the second pixel (PX2) and the third pixel (PX3).

13. The display device (10) of claim 11, wherein a distance between the first light blocking layer (BM1) and the light emitting elements (ED) in the first pixel (PX1) is greater than a distance between the first light blocking layer (BM1) and the light emitting elements (ED) in the second pixel (PX2) and the third pixel (PX3).

14. The display device (10) of claim 11, wherein the first light blocking layer (BM1) is spaced apart by a substantially uniform distance from the light emitting elements (ED) in the first pixel (PX1), the second pixel (PX2), and the third pixel (PX3) in plan view.

15. The display device (10) of claim 11, wherein in the second pixel (PX2), the openings (OP) of the first light blocking layer (BM1) and the openings (OP) of the second light blocking layer (BM2) have the same size.

16. The display device (10) of claim 11, wherein in the third pixel (PX3), the width of the openings (OP) of the first light blocking layer (BM1) is larger than the width of the openings (OP) of the second light blocking layer (BM2).

17. The display device (10) of claim 16, wherein in the third pixel (PX3), the openings (OP) of the second light blocking layer (BM2) are inside the openings (OP) of the first light blocking layer (BM1) in plan view.

18. The display device (10) of at least one of claims 1 to 17, wherein the second light blocking layer (BM2) is only in some pixels among pixels in the display area (DA), and is not in other pixels, and
wherein the some pixels comprise the second pixel (PX2) and the third pixel (PX3).

19. The display device (10) of at least one of claims 1 to 18, wherein the first light blocking layer (BM1) is in a non-emission area (NEA) of all pixels in the display area (DA), the all pixels comprising the first pixel (PX1), the second pixel (PX2), and the third pixel (PX3).

20. An electronic device comprising:
a display device, in particular a display device (10) according to at least one of claims 1 to 19, comprising:
a substrate (SUB) comprising a display area (DA) comprising emission areas (EA) of a first pixel (PX1), a second pixel (PX2), and a third pixel (PX3) and a non-emission area (NEA) surrounding the emission areas (EA);
a light emitting element layer (EML) on the substrate (SUB), and comprising light emitting elements (ED) in the emission areas (EA);
a color filter layer (CFD) on the light emitting element layer (EML), and comprising color filters (CF) in the emission areas (EA) and a first light blocking layer (BM1) in the non-emission area (NEA); and
a second light blocking layer (BM2) on the color filter layer (CFD), and in the non-emission area (NEA) of the second pixel (PX2) and the third pixel (PX3) while surrounding the emission areas (EA) of the second pixel (PX2) and the third pixel (PX3),
wherein the second light blocking layer (BM2) comprises openings (OP) having a width larger than a width of the light emitting elements (ED) of the second pixel (PX2) in the second pixel (PX2), and comprises openings (OP) having a width smaller than or equal to a width of the light emitting elements (ED) of the third pixel (PX3) in the third pixel (PX3).
